# EUROPEAN PATENT APPLICATION

(11) **EP 4 852 329 A1**
(43) Date of publication of application: **09.12.2026**
(21) Application number: 25760939.6
(22) Date of filing: 26.02.2025
(51) Int. Cl.: H03M 13/11

(54) **COMMUNICATION METHOD AND COMMUNICATION APPARATUS BASED ON LDPC CODE**

(30) Priority: 01.03.2024 CN 202410251136
(71) Applicant: HUAWEI TECHNOLOGIES CO., LTD., Shenzhen, Guangdong 518129 (CN)
(72) Inventor: LIU, Ke, Shenzhen, Guangdong 518129 (CN); ZHANG, Huazi, Shenzhen, Guangdong 518129 (CN); TONG, Jiajie, Shenzhen, Guangdong 518129 (CN); WANG, Xianbin, Shenzhen, Guangdong 518129 (CN); QIN, Kangjian, Shenzhen, Guangdong 518129 (CN); WANG, Jun, Shenzhen, Guangdong 518129 (CN)
(74) Representative: Huawei European IPR
(86) International application number: PCT/CN2025/079265
(87) International publication number: WO 2025/180399

(57) **Abstract**

A communication method based on an LDPC code and a communication apparatus are provided. Encoding or decoding may be performed based on an LDPC check matrix. The LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, k corresponding to at least one 1 element in the base matrix is an integer greater than 1, and Z_{c} is an integer greater than 1. Z_{c} and the k shifting values of each 1 element indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k cyclic shift matrices. The method can improve decoding performance for an LDPC code.

## Description

This application claims priority to Chinese Patent Application No. 202410251136.3, filed with the China National Intellectual Property Administration on March 1, 2024 and entitled "COMMUNICATION METHOD BASED ON LDPC CODE AND COMMUNICATION APPARATUS", which is incorporated herein by reference in its entirety.

### TECHNICAL FIELD

This application relates to the coding field, and more specifically, to a communication method based on an LDPC code and a communication apparatus.

### BACKGROUND

In the field of channel coding, low-density parity-check (low-density parity-check, LDPC) codes are one of the most mature and widely applied channel coding schemes. Quasi-cyclic low-density parity-check (quasi-cyclic low-density parity-check, QC-LDPC) codes are a class of structured LDPC codes. Due to the unique structure of the check matrix of the QC-LDPC codes, encoding can be implemented by using a simple feedback shift register, thereby reducing the encoding complexity of the LDPC codes.

Currently, the decoding threshold and decoding complexity of the QC-LDPC codes are mainly determined by a base matrix (or a base graph). A small-scale base matrix imposes significant limitations on the degree distribution of the LDPC codes, preventing the decoding threshold from being optimal. As a result, LDPC performance is severely degraded when a code rate is extremely high. The degree distribution of an LDPC code indicates the column weight distribution of the check matrix. In a possible implementation, the decoding threshold may be improved by expanding the base matrix. However, without introducing good orthogonality, a large-scale base matrix has low parallelism and complex hardware implementation.

### SUMMARY

Embodiments of this application provide a communication method based on an LDPC code and a communication apparatus to help improve decoding performance for an LDPC code.

According to a first aspect, a communication method based on an LDPC code is provided. The method may be performed by a transmitter device. Unless otherwise specified, the "transmitter device" in this application may be the transmitter device (for example, a network device or a terminal device), or may be a component (for example, a processor, a chip, or a chip system) in the transmitter device, or may be a logical module or software that can implement all or some functions of the transmitter device.

The method includes: obtaining an information bit sequence; determining an LDPC check matrix, where the LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, and k corresponding to at least one 1 element in the base matrix is an integer greater than 1, where Z_{c} and the k shifting values of each 1 element indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k cyclic shift matrices; encoding the information bit sequence based on the LDPC check matrix to obtain a codeword sequence; and outputting the codeword sequence.

In the foregoing technical solution, a plurality of shifting values are configured for the 1 element in the base matrix, and the corresponding 1 element is expanded to a plurality of cyclic shift matrices based on the plurality of shifting values. Compared with an expansion solution in which the 1 element in the base matrix corresponds to one shifting value, in this solution, the check matrix obtained through expansion supports a larger column weight, and has a better decoding threshold. In addition, a scale of the base matrix does not need to be expanded on the basis of optimizing the decoding threshold, thereby reducing hardware implementation complexity.

According to a second aspect, a communication method based on an LDPC code is provided. The method may be performed by a receiver device. Unless otherwise specified, the "receiver device" in this application may be the receiver device (for example, a network device or a terminal device), or may be a component (for example, a processor, a chip, or a chip system) in the receiver device, or may be a logical module or software that can implement all or some functions of the receiver device.

The method includes: obtaining a codeword sequence; determining an LDPC check matrix, where the LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, and k corresponding to at least one 1 element in the base matrix is an integer greater than 1, where Z_{c} and the k shifting values of each 1 element indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k cyclic shift matrices; and decoding the codeword sequence based on the LDPC check matrix to obtain an information bit sequence.

For beneficial effects of the second aspect, refer to the description in the first aspect. Details are not described herein again.

In some implementations of the first aspect and the second aspect, the method further includes: determining a first indicator *α*(*i*) associated with an i^{th} row of the base matrix and a second indicator *b*(*j*) associated with a j^{th} column of the base matrix, where a quantity k of shifting values corresponding to the 1 element located in the i^{th} row and the j^{th} column of the base matrix is equal to *α*(*i*) ∗ *b*(*j*), *α*(*i*) is an integer greater than or equal to 1, and *b*(*j*) is an integer greater than or equal to 1.

In some implementations of the first aspect and the second aspect, a first indicator associated with any row of the base matrix is 1, or a first indicator associated with any column of the base matrix is 1.

In some implementations of the first aspect and the second aspect, determining the LDPC check matrix includes: replacing a first element in the base matrix with *α*(*i*1)×*b*(*j*1) Z_{c}×Z_{c} cyclic shift matrices, where the *α*(*i*1)×*b*(*j*1) Z_{c}×Z_{c} cyclic shift matrices are matrices obtained by cyclically shifting the Z_{c}×Z_{c} identity matrix based on *α*(*i*1)×*b*(*j*1) shifting values corresponding to the first element; and replacing a second element in the base matrix with *α*(*i*2)×*b*(*j*2) Z_{c}×Z_{c} all-0 matrices to obtain the LDPC check matrix, where the first element is a 1 element located in a row *i*1 and a column *j*1, the second element is a 0 element located in a row *i*2 and a column *j*2, the *α*(*i*1)×*b*(*j*1) Z_{c}×Z_{c} cyclic shift matrices form one (*α*(*i*1)×Z_{c})×(*b*(*j*1)×Z_{c}) matrix, and the *α*(*i*2)×*b*(*j*2) Z_{c}×Z_{c} all-0 matrices form one (*α*(*i*2)×Z_{c})×(*b*(*j*2)×Z_{c}) all-0 matrix.

In some implementations of the first aspect and the second aspect, determining the LDPC check matrix includes: replacing a first element with an *α*(*i*1)×*b*(*j*1) all-1 matrix, and replacing a second element with an *α*(*i*2)×*b*(*j*2) all-0 matrix, where the first element is a 1 element located in a row *i*1 and a column *j*1, and the second element is a 0 element located in a row *i*2 and a column *j*2; replacing each 1 in the *α*(*i*1)×*b*(*j*1) all-1 matrix with a Z_{c}×Z_{c} cyclic shift matrix, where *α*(*i*1)×*b*(*j*1) Z_{c}×Z_{c} cyclic shift matrices after the replacement are matrices obtained by cyclically shifting the Z_{c}×Z_{c} identity matrix based on *α*(*i*1) × *b*(*j*1) shifting values corresponding to the first element; and replacing 0 in the *α*(*i*2)×*b*(*j*2) all-0 matrix with a Z_{c}×Z_{c} all-0 matrix to obtain the LDPC check matrix.

In some implementations of the first aspect and the second aspect, the *α*(*i*1)×*b*(*j*1) shifting values of the first element are in one-to-one correspondence with the *α*(*i*1)×*b*(*j*1) Z_{c}×Z_{c} cyclic shift matrices in an order of row-first and column-second; or the *α*(*i*1)×*b*(*j*1) shifting values of the first element are in one-to-one correspondence with the *α*(*i*1)×*b*(*j*1) Z_{c}×Z_{c} cyclic shift matrices in an order of column-first and row-second.

In some implementations of the first aspect and the second aspect, determining the first indicator *α*(*i*) associated with the i^{th} row of the base matrix and the second indicator *b*(*j*) associated with the j^{th} column of the base matrix includes: determining, based on first indication information, a first indicator associated with each row of the base matrix, where the first indication information indicates first indicators associated with all rows of the base matrix; and determining, based on second indication information, a second indicator associated with each column of the base matrix, where the second indication information indicates second indicators associated with all columns of the base matrix.

In some implementations of the first aspect and the second aspect, determining the first indicator *α*(*i*) associated with the i^{th} row of the base matrix and the second indicator *b*(*j*) associated with the j^{th} column of the base matrix includes: determining, based on first indication information and the quantity k of shifting values corresponding to the 1 element in the base matrix, a first indicator associated with each row of the base matrix and a second indicator associated with each column of the base matrix, where the first indication information indicates first indicators associated with all rows of the base matrix; or determining, based on second indication information and the quantity k of shifting values corresponding to the 1 element in the base matrix, a first indicator associated with each row of the base matrix and a second indicator associated with each column of the base matrix, where the second indication information indicates second indicators associated with all columns of the base matrix.

In the foregoing technical solution, only the first indication information may be indicated, and a device (the transmitter device or the receiver device) may determine, based on the quantity k of shifting values corresponding to the 1 element in the base matrix, a second indicator associated with a column in which the 1 element is located. Similarly, only the second indication information may be indicated, and a device (the transmitter device or the receiver device) may determine, based on the quantity k of shifting values corresponding to the 1 element in the base matrix, a first indicator associated with a row in which the 1 element is located.

In some implementations of the first aspect and the second aspect, the first indication information is a first sequence, and/or the second indication information is a second sequence.

For example, the first sequence and/or the second sequence may be defined in a protocol.

In some implementations of the first aspect and the second aspect, quantities k of shifting values corresponding to all 1 elements in an information column of the base matrix are equal to 2, 3, 4, or 6.

In some implementations of the first aspect and the second aspect, a storage matrix indicates the base matrix and the k shifting values corresponding to each 1 element in the LDPC base matrix.

In some implementations of the first aspect and the second aspect, the storage matrix includes a first shifting value and a first function that correspond to the first element in the base matrix, the first element is a 1 element in the base matrix, a quantity k of shifting values corresponding to the first element is greater than 1, and the method further includes: determining, based on the first shifting value and the first function, the other k-1 shifting values corresponding to the first element.

According to a third aspect, a communication method based on an LDPC code is provided. The method may be performed by a transmitter device. Unless otherwise specified, the "transmitter device" in this application may be the transmitter device (for example, a network device or a terminal device), or may be a component (for example, a processor, a chip, or a chip system) in the transmitter device, or may be a logical module or software that can implement all or some functions of the transmitter device.

The method includes: obtaining an information bit sequence; determining an LDPC check matrix, where the LDPC check matrix is determined based on an LDPC base matrix, a lifting size Z_{c}, a shifting value corresponding to each 1 element in the base matrix, and a quantity of shifting values corresponding to each 1 element, the quantity of shifting values corresponding to each 1 element is k, k is an integer greater than 1, k shifting values corresponding to at least one 1 element in the base matrix include at least one first-type shifting value and at least one second-type shifting value, all k shifting values corresponding to a remaining 1 element other than the at least one 1 element in the base matrix are first-type shifting values, the first-type shifting value is an integer greater than or equal to 0 and less than or equal to Zₘₐₓ-1, the second-type shifting value is not equal to the first-type shifting value, and Zₘₐₓ is a maximum lifting size corresponding to Z_{c}, where Z_{c} and the k shifting values of each 1 element indicate replacement of the corresponding 1 element with k1 Z_{c}×Z_{c} cyclic shift matrices and k2 Z_{c}×Z_{c} all-0 matrices, k1 and k2 are respectively a quantity of first-type shifting values and a quantity of second-type shifting values in the k shifting values of the corresponding 1 element, a sum of k1 and k2 is equal to k, the k1 Z_{c}×Z_{c} cyclic shift matrices are obtained by separately cyclically shifting a Z_{c}×Z_{c} identity matrix, and the k1 first-type shifting values are quantities of cyclic shifts corresponding to the k1 Z_{c}×Z_{c} cyclic shift matrices; encoding the information bit sequence based on the LDPC check matrix to obtain a codeword sequence; and outputting the codeword sequence.

In the foregoing technical solution, a plurality of shifting values are configured for the 1 element in the base matrix, and the corresponding 1 element is expanded to a plurality of cyclic shift matrices based on the plurality of shifting values. Compared with an expansion solution in which the 1 element in the base matrix corresponds to one shifting value, in this solution, the check matrix obtained through expansion supports a larger column weight, and has a better decoding threshold. In addition, a scale of the base matrix does not need to be expanded on the basis of optimizing the decoding threshold, thereby reducing hardware implementation complexity.

It may be understood that, in the solution shown in the first aspect, the quantities of shifting values corresponding to the 1 elements in the base matrix may be different. However, when the quantities of shifting values are different, a decoding threshold cannot be optimal, actual performance is degraded, and hardware implementation complexity is high. In this solution, the second-type shifting value is used to ensure a same quantity of shifting values of each 1 element in the base matrix, so that hardware implementation complexity can be reduced and the decoding threshold can be optimized.

According to a fourth aspect, a de-interleaving method is provided. The method may be performed by a receiver device. Unless otherwise specified, the "receiver device" in this application may be the receiver device (for example, a network device or a terminal device), or may be a component (for example, a processor, a chip, or a chip system) in the receiver device, or may be a logical module or software that can implement all or some functions of the receiver device.

The method includes: obtaining a codeword sequence; determining an LDPC check matrix, where the LDPC check matrix is determined based on an LDPC base matrix, a lifting size Z_{c}, a shifting value corresponding to each 1 element in the base matrix, and a quantity of shifting values corresponding to each 1 element, the quantity of shifting values corresponding to each 1 element is k, k is an integer greater than 1, k shifting values corresponding to at least one 1 element in the base matrix include at least one first-type shifting value and at least one second-type shifting value, all k shifting values corresponding to a remaining 1 element other than the at least one 1 element in the base matrix are first-type shifting values, the first-type shifting value is greater than or equal to 0 and less than or equal to Zₘₐₓ-1, the second-type shifting value is not equal to the first-type shifting value, and Zₘₐₓ is a maximum lifting size corresponding to Z_{c}, where Z_{c} and the k shifting values of each 1 element indicate replacement of the corresponding 1 element with k1 Z_{c}×Z_{c} cyclic shift matrices and k2 Z_{c}×Z_{c} all-0 matrices, k1 and k2 are respectively a quantity of first-type shifting values and a quantity of second-type shifting values in the k shifting values of the corresponding 1 element, a sum of k1 and k2 is equal to k, the k1 Z_{c}×Z_{c} cyclic shift matrices are obtained by separately cyclically shifting a Z_{c}×Z_{c} identity matrix, and the k1 first-type shifting values are quantities of cyclic shifts corresponding to the k1 Z_{c}×Z_{c} cyclic shift matrices; and decoding the codeword sequence based on the LDPC check matrix to obtain an information bit sequence.

For beneficial effects of the fourth aspect, refer to the description in the third aspect. Details are not described herein again.

In some implementations of the third aspect and the fourth aspect, the second-type shifting value is equal to -1.

In some implementations of the third aspect and the fourth aspect, the method further includes: determining a first indicator *α* associated with each row of the base matrix and a second indicator *b* associated with each column of the base matrix, where a quantity k of shifting values corresponding to any 1 element in the base matrix is equal to *α* ∗ *b*, *α* is an integer greater than or equal to 1, and *b* is an integer greater than or equal to 1.

In some implementations of the third aspect and the fourth aspect, a first indicator associated with any row of the base matrix is 1, or a first indicator associated with any column of the base matrix is 1.

In some implementations of the third aspect and the fourth aspect, determining the LDPC check matrix includes: replacing a 1 element in the base matrix with k1 Z_{c}×Z_{c} cyclic shift matrices and k2 Z_{c}×Z_{c} all-0 matrices, where the k1 Z_{c}×Z_{c} cyclic shift matrices are matrices obtained by cyclically shifting the Z_{c}×Z_{c} identity matrix based on k1 shifting values corresponding to the 1 element; and replacing a 0 element in the base matrix with *α* ∗ *b* Z_{c}×Z_{c} all-0 matrices to obtain the LDPC check matrix, where the k1 Z_{c}×Z_{c} cyclic shift matrices and the k2 Z_{c}×Z_{c} all-0 matrices form one ( *α* ×Z_{c})×( *b* ×Z_{c}) matrix, and the *α* ∗ *b* Z_{c}×Z_{c} all-0 matrices form one (*a*×Z_{c})×(*b*×Z_{c}) all-0 matrix.

In some implementations of the third aspect and the fourth aspect, determining the LDPC check matrix includes: replacing a 1 element in the base matrix with an *a*×*b* matrix, where k shifting values corresponding to the 1 element in the base matrix are in one-to-one correspondence with positions of k elements in the *α* × *b* matrix, and if a shifting value corresponding to a first position in the *α*×*b* matrix is the first-type shifting value, an element corresponding to the first position is 1, or if a shifting value corresponding to the first position is the second-type shifting value, an element corresponding to the first position is 0; replacing each 0 element in the base matrix with an *α*×*b* all-0 matrix; replacing each 1 in the *α*×*b* matrix with a Z_{c}×Z_{c} cyclic shift matrix, where the cyclic shift matrix is a matrix obtained by cyclically shifting the Z_{c}×Z_{c} identity matrix based on a shifting value corresponding to a position of each 1 in the *α*×*b* matrix; replacing each 0 in the *α*×*b* matrix with a Z_{c}×Z_{c} all-0 matrix; and replacing each 0 in the *α*×*b* all-0 matrix with a Z_{c}×Z_{c} all-0 matrix to obtain the LDPC check matrix.

In some implementations of the third aspect and the fourth aspect, the *k*1 shifting values of the 1 element are in one-to-one correspondence, in an order of row-first and column-second, with all Z_{c}×Z_{c} matrices in the (*a*×Z_{c})×(*b*×Z_{c}) matrix obtained by lifting the 1 element; or the *k*1 shifting values of the 1 element are in one-to-one correspondence, in an order of column-first and row-second, with all Z_{c}×Z_{c} matrices in the (*a*×Z_{c})×(*b*×Z_{c}) matrix obtained by lifting the 1 element.

In some implementations of the third aspect and the fourth aspect, determining the first indicator *α* associated with each row of the base matrix and the second indicator *b* associated with each column of the base matrix includes: determining, based on first indication information, the first indicator associated with each row of the base matrix, where the first indication information indicates first indicators associated with all rows of the base matrix; and determining, based on second indication information, the second indicator associated with each column of the base matrix, where the second indication information indicates second indicators associated with all columns of the base matrix.

In some implementations of the third aspect and the fourth aspect, determining the first indicator *α* associated with each row of the base matrix and the second indicator *b* associated with each column of the base matrix includes: determining, based on first indication information and the quantity k of shifting values corresponding to the 1 element in the base matrix, the first indicator associated with each row of the base matrix and the second indicator associated with each column of the base matrix, where the first indication information indicates first indicators associated with all rows of the base matrix; or determining, based on second indication information and the quantity k of shifting values corresponding to the 1 element in the base matrix, the first indicator associated with each row of the base matrix and the second indicator associated with each column of the base matrix, where the second indication information indicates second indicators associated with all columns of the base matrix.

In some implementations of the third aspect and the fourth aspect, the first indication information is a first sequence, and/or the second indication information is a second sequence.

In some implementations of the third aspect and the fourth aspect, k is equal to 2, 3, 4, or 6.

In some implementations of the third aspect and the fourth aspect, a storage matrix indicates the base matrix and the k shifting values corresponding to each 1 element in the base matrix.

In some implementations of the third aspect and the fourth aspect, the storage matrix includes a first shifting value and a first function that correspond to a first element in the base matrix, the first element is a 1 element in the base matrix, a quantity k1 of first-type shifting values corresponding to the first element is greater than 1, and the method further includes:
determining, based on the first shifting value and the first function, the other k1-1 first-type shifting values corresponding to the first element.

According to a fifth aspect, a communication apparatus is provided. The apparatus is configured to perform the method provided in any one of the foregoing aspects or the implementations of the foregoing aspects. Specifically, the apparatus may include a unit and/or a module, for example, a processing unit and/or a transceiver unit, configured to perform the method provided in any one of the foregoing aspects or the implementations of the foregoing aspects.

In an implementation, the apparatus is a transmitter device or a receiver device. When the apparatus is the transmitter device or the receiver device, the transceiver unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used in a transmitter device or a receiver device. When the apparatus is the chip, the chip system, or the circuit used in the transmitter device or the receiver device, the transceiver unit may be an input/output interface, an interface circuit, an output circuit, an input circuit, a pin, a related circuit, or the like on the chip, the chip system, or the circuit; and the processing unit may be at least one processor, a processing circuit, a logic circuit, or the like.

According to a sixth aspect, a communication apparatus is provided. The apparatus includes a memory, configured to store a program; and at least one processor, configured to execute the computer program or instructions stored in the memory, to perform the method provided in any one of the foregoing aspects or the implementations of the foregoing aspects.

In an implementation, the apparatus is a transmitter device or a receiver device.

In another implementation, the apparatus is a chip, a chip system, or a circuit used in a transmitter device or a receiver device.

According to a seventh aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to an eighth aspect, a processor is provided. The processor is configured to perform the methods provided in the foregoing aspects.

Operations such as sending and obtaining/receiving related to the processor may be understood as operations such as output and receiving or input of the processor, or operations such as sending and receiving performed by a radio frequency circuit and an antenna, unless otherwise specified, or provided that the operations do not contradict actual functions or internal logic of the operations in related descriptions. This is not limited in this application.

According to a ninth aspect, a computer-readable storage medium is provided. The computer-readable storage medium stores program code to be executed by a device, and the program code is used to perform the method provided in any one of the foregoing aspects or the implementations of the foregoing aspects.

According to a tenth aspect, a computer program product including instructions is provided. When the computer program product runs on a computer, the computer is caused to perform the method provided in any one of the foregoing aspects or the implementations of the foregoing aspects.

According to an eleventh aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes a memory. The memory stores a computer program or instructions. The processor is configured to execute the computer program or the instructions stored in the memory. When the computer program or the instructions are executed, the processor is configured to perform the method provided in any one of the foregoing aspects or the implementations of the foregoing aspects.

When the method provided in this application is performed by the chip, a quantity of chips that specifically implement the method in this application is not limited in this application. For example, the method may be performed by one chip, or may be performed by two or more chips. In addition, when two or more chips implement the method in this application, a chip vendor is not limited. The chips may be from a same vendor or from different vendors.

According to a twelfth aspect, a communication system is provided, and includes at least one of the transmitter device or the receiver device described above.

According to a thirteenth aspect, a computer program is provided. When the computer program is run on a computer, the method provided in any one of the foregoing aspects or the implementations of the foregoing aspects is performed.

### BRIEF DESCRIPTION OF DRAWINGS

FIG. 1 is a diagram of a network architecture to which an embodiment of this application may be applied;
FIG. 2 is a diagram of an LDPC check matrix H;
FIG. 3 is a Tanner (Tanner) graph of an LDPC check matrix H;
FIG. 4A and FIG. 4B are diagrams of structures of a check matrix;
FIG. 5 is a diagram of an information transmission procedure;
FIG. 6 is a schematic flowchart of a communication method 500 based on an LDPC code according to this application;
FIG. 7 is a diagram of *α*(*i*) corresponding to each row and *b*(*j*) corresponding to each column in a base matrix;
FIG. 8 is a diagram of performance simulation for an LDPC code proposed based on this application and an LDPC code based on BG1;
FIG. 9 is a diagram of a multi-edge LDPC code;
FIG. 10 is a block diagram of a communication apparatus 1000 according to an embodiment of this application; and
FIG. 11 is a block diagram of a communication apparatus 1100 according to an embodiment of this application.

### DESCRIPTION OF EMBODIMENTS

For ease of understanding embodiments of this application, before embodiments of this application are described, the following descriptions are first provided.

"Indicating" or "indicate" may include a direct indication and an indirect indication, or "indicating" or "indicate" may be an explicit indication and/or an implicit indication. Various numerical numbers such as first and second are merely used for differentiation for ease of description, and are not used to limit the scope of embodiments of this application, for example, are used to distinguish between different messages and different information. "Predefinition" may be implemented by pre-storing, in a device, corresponding code or a table, or may be implemented in another manner that may be used for indicating related information. A specific implementation of "predefinition" is not limited in this application. A related "protocol" may be a standard protocol in the communication field, for example, may include a long term evolution (long term evolution, LTE) protocol, a new radio (new radio, NR) protocol, and a related protocol applied to a future communication system. This is not limited in this application. Words such as "example", "for example", "for instance", and "in an (another) example" represent giving an example, an illustration, or a description. Any embodiment or design scheme described as an "example" in this application should not be explained as being more preferred or having more advantages than another embodiment or design scheme. The terms "include", "contain", "have", and variations thereof all mean "including but not limited to", unless otherwise specifically emphasized in another manner. "At least one" means one or more, and "a plurality of" means two or more. "At most one" means one or zero. The term "and/or" describes an association relationship of associated objects, and indicates that three relationships may exist. For example, A and/or B may indicate the following three cases: Only A exists, both A and B exist, and only B exists. A and B may be singular or plural. The character "/" usually indicates an "or" relationship between the associated objects. "At least one of the following items (pieces)" or a similar expression thereof refers to any combination of these items, including a single item (piece) or any combination of a plurality of items (pieces). For example, at least one of a, b, and c may indicate a, b, c, a and b, a and c, b and c, or a, b, and c. Each of a, b, and c may be singular or plural. Related descriptions about sending a message, information, or data by a network element A to a network element B and receiving the message, information, or data by the network element B from the network element A are intended to describe a network element to which the message, information, or data is to be sent. Whether the message, information, or data is directly sent or indirectly sent via another network element is not limited. Descriptions such as "when ...", "in a case of ...", and "if" all mean that a device performs corresponding processing in a specific objective situation, and are not intended to limit time. The descriptions do not mean that the device is required to have a determining action during implementation, and do not mean any other limitation.

In addition, the network architecture and the service scenario described in embodiments of this application are intended to describe the technical solutions in embodiments of this application more clearly, and do not constitute a limitation on the technical solutions provided in embodiments of this application. A person of ordinary skill in the art may know that, with the evolution of the network architecture and the emergence of new service scenarios, the technical solutions provided in embodiments of this application are also applicable to similar technical problems.

The following describes communication systems to which embodiments of this application may be applied.

Embodiments of this application may be applied to various communication systems, including but not limited to a 5th generation (5th generation, 5G) system, an LTE system, a long term evolution-advanced (long term evolution-advanced, LTE-A) system, an LTE frequency division duplex (frequency division duplex, FDD) system, an LTE time division duplex (time division duplex, TDD) system, and the like. Embodiments of this application may be further applied to a future communication system, for example, a 6th generation mobile communication system. In addition, embodiments of this application may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system, a narrow band-internet of things (narrow band-internet of things, NB-IoT) system, or another communication system. In addition, embodiments of this application may be further extended to similar wireless communication systems, for example, communication systems related to wireless fidelity (wireless fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to embodiments of this application may include one or more transmitter devices and one or more receiver devices. Optionally, one of the transmitter device and the receiver device may be a terminal device, and the other may be a network device. Optionally, both the transmitter device and the receiver device may be terminal devices. Optionally, both the transmitter device and the receiver device may be network devices.

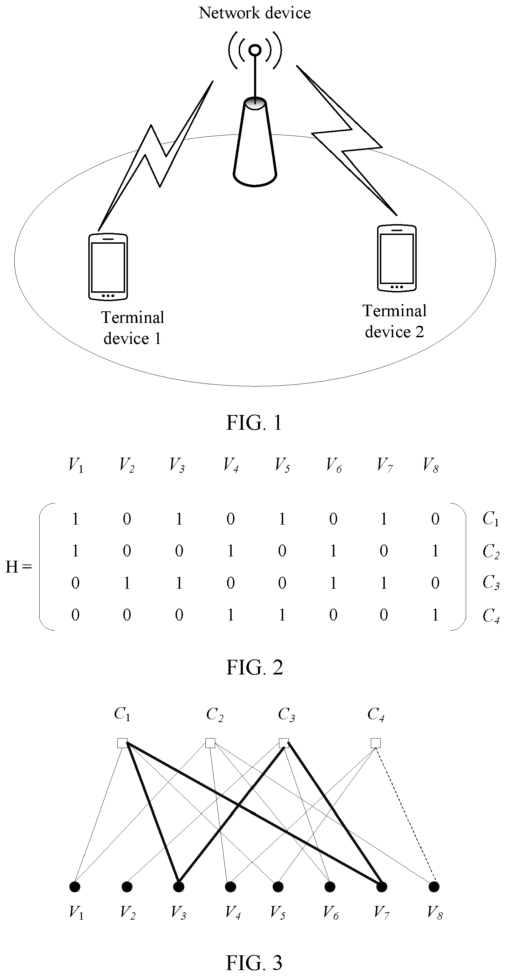

FIG. 1 is a diagram of a network architecture applicable to an embodiment of this application. As shown in FIG. 1, embodiments of this application are applicable to both uplink data transmission and downlink data transmission. In FIG. 1, only uplink data transmission or downlink data transmission between one network device and two terminal devices (for example, a terminal device 1 and a terminal device 2) is used as an example. For the uplink data transmission, in this specification, the transmitter device is the terminal device, and the receiver device is the network device. Conversely,, for the downlink data transmission, the transmitter device is the network device, and the receiver device is the terminal device. In addition, applicability of embodiments of this application in another communication scenario is not limited. For example, embodiments of this application may also be applied to sidelink communication.

The terminal device in this application may also be referred to as user equipment (user equipment, UE), an access terminal, a subscriber unit, a subscriber station, a mobile station, a mobile terminal (mobile terminal, MT), a remote station, a remote terminal, a mobile device, a user terminal, a terminal, an uncrewed aerial vehicle, a wireless communication device, a user agent, a user apparatus, or the like. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having wireless receiving and sending functions. The network device may be a device that provides a wireless communication function service, is usually located on a network side, and includes but is not limited to a next generation base station (gNodeB, gNB) in a 5G system, a base station in a 6th generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB or a home NodeB, HNB), a baseband unit (baseband unit, BBU), a transmission reception point (transmission reception point, TRP), a transmitting point (transmitting point, TP), a base transceiver station (base transceiver station, BTS), a satellite, an uncrewed aerial vehicle, or the like. In a network structure, the network device may include a central unit (central unit, CU) node or a distributed unit (distributed unit, DU) node, or may be a RAN device including a CU node and a DU node, or may be a RAN device including a control plane CU node, a user plane CU node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip that is disposed in the foregoing device or apparatus. The base station may alternatively be a mobile switching center, a device that undertakes a base station function in D2D, V2X, or M2M communication, a network side device in a 6G network, a device that undertakes a base station function in a future communication system, or the like. The base station may support networks using a same access technology or different access technologies. This is not limited.

Unless otherwise specified, in this application, an apparatus configured to implement a function of the terminal device or the network device may be the terminal device or the network device, or may be an apparatus that can support the terminal device or the network device in implementing the function, for example, a chip system or a chip. Specifically, the apparatus is a system on a chip (system on a chip, SoC) or a modem (Modem). The apparatus may be mounted in the terminal device or the network device. In embodiments of this application, the chip system may include a chip, or may include a chip and another discrete component.

It should be further noted that in some embodiments of this specification, a 5G system is used as an example to describe details of specific solutions. It may be understood that when the solutions are applied to another communication system, for example, an LTE system or a future communication system, messages, channels, information, or the like in the solutions may be replaced with messages, channels, information, or the like that can implement corresponding functions in the another communication system. This is not limited in this application.

In addition, embodiments of this application may be applied to various application scenarios, for example, a high-throughput scenario, a high-reliability scenario, a low-latency scenario, a high-reliability and low-latency scenario, or a low-power scenario. The high-throughput scenario may be, for example, an enhanced mobile broadband (enhanced mobile broadband, eMBB) scenario. The high-reliability and low-latency scenario may be, for example, a URLLC (ultra-reliable low-latency communication) scenario. The low-power scenario may be, for example, an M2M scenario, an MTC scenario, or an IoT scenario.

To facilitate understanding of embodiments of this application, several concepts or terms in embodiments of this application are briefly described. The concepts or the terms described below are described based on concepts or terms specified in protocols. However, this does not mean that embodiments of this application can be applied only to currently existing systems, and the concepts or the terms in embodiments of this application can be applied to future systems. In addition, specific names of the concepts or the terms (for example, concepts or terms related to functional descriptions) may be adjusted with the development of the future systems.

### 1. LDPC code

The LDPC code is a linear block code. The linear block code means that a to-be-encoded information sequence is divided into groups in a unit of q bits, and then an encoder performs a linear operation on the q information bits to obtain m check bits. Then, the q information bits are combined with the m check bits to obtain a codeword with a length of n=q+m. A mapping relationship between the q information bits and the codeword with a length of n bits is usually represented by a corresponding check matrix H. A codeword sequence can be correspondingly generated based on the check matrix H to complete an encoding process. After the codeword sequence is transmitted through a channel, a receiver device correspondingly decodes a received signal, to determine an original information bit.

The LDPC check matrix H is a sparse matrix. A quantity of zero elements in the check matrix H is far greater than a quantity of non-zero elements. In other words, a row weight (or a column weight) of the check matrix is far less than a quantity of elements in each row (or each column) of the LDPC matrix. The LDPC code whose information bit sequence length is equal to q and whose code length is equal to n can be uniquely determined by the check matrix H of the LDPC code.

In 1981, Tanner (Tanner) represented a check matrix H in a manner of a graph. Such a graph is referred to as a Tanner graph now. The Tanner graph is in one-to-one correspondence with the check matrix. The Tanner graph includes two types of vertices. One type of vertex represents a codeword bit and is referred to as a variable node. The other type of vertex is a check node and represents a check constraint relationship. Each check node represents one check constraint relationship. The following provides descriptions with reference to FIG. 2 and FIG. 3.

FIG. 2 is a diagram of an LDPC check matrix H.

In FIG. 2, {Vᵢ} represents a variable node (variable node, VN) set, and {Cᵢ} represents a check node (check node, CN) set. In the check matrix H, each row represents one check equation, each check equation corresponds to one check node, each column represents one codeword bit, and each codeword bit corresponds to one variable node. In FIG. 2, there are eight variable nodes and four check nodes. If a codeword bit is included in a corresponding check equation, a related variable node and check node are connected by using a connection line, to obtain a Tanner graph.

FIG. 3 is a Tanner graph of an LDPC check matrix H.

As shown in FIG. 3, the Tanner graph represents the LDPC check matrix. For example, for a check matrix H with a size of m rows and n columns, a Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph includes vertices connected to each other. One of the vertices is used as both a start point and an end point of the cycle, and the cycle passes through each node only once. A length of the cycle is defined as a quantity of edges included in the cycle. A girth of the graph may also be referred to as a perimeter of the graph, and is defined as a minimum cycle length in the graph. In FIG. 3, the girth is 4, as shown by bold connection lines in FIG. 3. The variable nodes in the Tanner graph each correspond to one column of the check matrix H, that is, correspond to one codeword bit of LDPC. The check nodes in the Tanner graph each correspond to one row of the check matrix H, that is, correspond to a check bit of LDPC. A connection between the two types of nodes corresponds to a value of an element in the matrix H. If a connection exists between an i^{th} check node and a j^{th} variable node, it indicates that a value of an element (i, j) in the matrix H is 1. If there is no connection, it indicates that a corresponding element is 0. A connection line between the variable node and the check node may also be referred to as an edge. That a connection exists between the check node and the variable node may also be described as that there is a connection or an edge between the check node and the variable node. An edge relationship between the check node and the variable node may include two cases: an edge exists or no edge exists. In addition, in the Tanner graph, the cycle (cycle) is a closed loop including variable nodes, check nodes, and edges that are connected end to end.

### 2. QC-LDPC code

Quasi-cyclic low-density parity-check (quasi-cyclic low-density parity-check, QC-LDPC) codes are a class of structured LDPC codes. Due to a unique structure of a check matrix of the QC-LDPC code, encoding can be implemented by using a simple feedback shift register, so that encoding complexity of the LDPC code is reduced. An actually used QC-LDPC code is represented by using a base graph (base graph, BG). An element in the BG is 0 or 1. 1 and 0 in the BG are expanded. A check matrix H is obtained after expansion is completed, and may be used for encoding or decoding. In embodiments of this application, the BG may be written in a form of a matrix, which may be referred to as a base matrix H_{BG} in this application. In the base matrix H_{BG}, if an element is 0, it indicates that no edge exists in the base graph; or if a value of an element is 1, it indicates that an edge exists in the base graph (or indicates that a corresponding check is associated with a corresponding variable). An NR LDPC code relates to multi-base graph selection. Currently, two base graphs are stored in a standard: BG1 and BG2. When an information length is less than or equal to 292, or an information length is less than or equal to 3824 and a code rate is less than or equal to 2/3, or a code rate is less than or equal to 0.25, BG2 is used; otherwise, BG1 is used. The following describes a process of expanding the base matrix.

Based on the base matrix and a lifting size Z_{c} (lifting size), the base matrix can be expanded to a complete check matrix for encoding or decoding. In this application, Z_{c} may also be referred to as an expansion factor, a lifting factor, an expansion value, an expansion coefficient, a lifting size, and the like. In the expansion process, each element in the base matrix is lifted to a Z_{c}×Z_{c} square matrix. 0 is lifted to a Z_{c}×Z_{c} all-0 matrix. 1 is lifted to an identity matrix, and a cyclic shift is performed on the identity matrix based on a shifting value (shifting value, SV) corresponding to 1. The cyclic shift may be leftward or rightward. This is not limited in this application. It may be understood that each 1 in the base matrix corresponds to a shifting value. A 4×4 identity matrix is used as an example. When the shifting value is separately 0, 1, and 3, a cyclic shift matrix after a rightward cyclic shift is shown as follows:
(1) When the shifting value is 0 (that is, remains unchanged), a corresponding matrix after the cyclic shift is $\left[\begin{matrix}1 & 0 & 0 & 0 \\ 0 & 1 & 0 & 0 \\ 0 & 0 & 1 & 0 \\ 0 & 0 & 0 & 1\end{matrix}\right]$.
(2) When the shifting value is 1, a corresponding matrix after the cyclic shift is $\left[\begin{matrix}0 & 1 & 0 & 0 \\ 0 & 0 & 1 & 0 \\ 0 & 0 & 0 & 1 \\ 1 & 0 & 0 & 0\end{matrix}\right]$.
(3) When the shifting value is 3, a corresponding matrix after the cyclic shift is $\left[\begin{matrix}0 & 0 & 0 & 1 \\ 1 & 0 & 0 & 0 \\ 0 & 1 & 0 & 0 \\ 0 & 0 & 1 & 0\end{matrix}\right]$.

It may also be understood that the complete check matrix H may be represented by an exponential matrix H_{b}, each element in H_{b} corresponds to a Z_{c}×Z_{c} submatrix, and each element identifies a quantity of cyclic shifts from an identity matrix to a corresponding submatrix. Therefore, storage space required by the complete check matrix H is greatly reduced. The element in the exponential matrix H_{b} may also be referred to as a QC block.

For example, an exponential matrix H_{b} of the QC-LDPC code is shown as follows: $\left[\begin{matrix}13 & 48 & 80 & 66 & 4 & 74 & 7 & 30 & 76 & 52 & 37 & 60 & - 1 & 49 & - 1 & 73 & 31 & 74 & 73 & 23 & 1 & 0 & - 1 & - 1 \\ 69 & 63 & 74 & 56 & 64 & 77 & 57 & 65 & 6 & 16 & 51 & - 1 & 64 & - 1 & 64 & 68 & 9 & 48 & 62 & 54 & - 1 & 0 & 0 & - 1 \\ 51 & 15 & 0 & 80 & 24 & 25 & 42 & 54 & 44 & 71 & 71 & 9 & 67 & 35 & 67 & - 1 & 58 & - 1 & 29 & - 1 & 0 & - 1 & 0 & 0 \\ 16 & 29 & 36 & 41 & 44 & 56 & 59 & 37 & 50 & 24 & - 1 & 65 & 4 & 65 & 4 & 52 & - 1 & 4 & - 1 & 73 & 1 & - 1 & - 1 & 0\end{matrix}\right]$

It can be learned that a size of the exponential matrix H_{b} is 4 rows and 24 columns, each element i in the exponential matrix H_{b} represents a Z_{c}-order square matrix ${P}_{{Z}_{c}}^{i} {, P}_{{Z}_{c}}^{i}$ represents a cyclic shift matrix, i represents a cyclic shift value of the cyclic shift matrix, and i is an integer. In addition, in the exponential matrix H_{b}, "-1" represents an all-zero matrix, and "0" represents an identity matrix.

For example, ${P}_{{Z}_{c}}^{1}$ is shown as follows: ${P}_{{Z}_{c}}^{1} = \left[\begin{matrix}0 & 1 & 0 & … & 0 \\ 0 & 0 & 1 & … & 0 \\ ⋮ & ⋮ & ⋮ & ⋱ & ⋮ \\ 0 & 0 & 0 & … & 1 \\ 1 & 0 & 0 & … & 0\end{matrix}\right]$

Optionally, in addition to "-1", a zero element in the exponential matrix H_{b} may be alternatively expressed in another form. For example, "-" or a null value is used to represent the all-zero matrix.

It may be understood that a corresponding matrix obtained by changing a position greater than or equal to 0 in the exponential matrix H_{b} to 1 and changing a position of -1 to 0 is a base matrix. 1 in the base matrix is expanded to a cyclic shift matrix based on an element at a corresponding position in the exponential matrix, 0 is expanded to an all-0 matrix of a corresponding scale, and a check matrix is obtained after expansion is completed.

### 3. Lifting size Z_{c} (Lifting Size) and shifting value (Shifting Value)

Storage content of a 5G LDPC code regarding a shifting (shifting) value includes: (1) a lifting size (Lifting Size) list; and (2) a list of shifting values (Shifting Value) that are in one-to-one correspondence with rows of the lifting size list.

For example, the lifting size list is shown in Table 1.

**Table 1**

| Lifting size index | Set of lifting sizes |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

A *j*^{th} row of the lifting size list includes *aⱼ*×2*^{k^{j}},* where *aⱼ* ∈ {2,3,5,7,9,11,13,15}, and max(*kⱼ*) ∈ {7,7,6,5,5,5,4,4}. A row mark of the lifting size is in one-to-one correspondence with a column mark of the shifting value, that is, lifting sizes in each row of the lifting size list correspond to a group of shifting values.

For example, the shifting value list is shown in Table 2.

**Table 2**

| H_{BG} | | Shifting value | | | | | | | |
|---|---|---|---|---|---|---|---|---|---|
| Row index | Column index (edge) | Lifting size index | | | | | | | |
| | | 0 | 1 | 2 | 3 | 4 | 5 | 6 | 7 |
| 0 | 0 | 211 | 39 | 102 | 216 | 6 | 86 | 13 | 183 |
| | 1 | 165 | 141 | 22 | 211 | 120 | 62 | 112 | 157 |
| | 5 | 111 | 68 | 116 | 221 | 18 | 170 | 1 | 204 |
| | 8 | 243 | 174 | 98 | 127 | 123 | 94 | 194 | 73 |
| | 13 | 8 | 34 | 142 | 114 | 88 | 26 | 64 | 48 |
| | 16 | 209 | 66 | 79 | 203 | 50 | 63 | 125 | 53 |
| | 19 | 98 | 179 | 101 | 174 | 110 | 132 | 108 | 84 |
| 1 | 0 | 177 | 33 | 90 | 0 | 129 | 124 | 118 | 226 |
| | 1 | 170 | 181 | 50 | 177 | 72 | 60 | 106 | 60 |
| | 6 | 205 | 188 | 73 | 66 | 18 | 117 | 113 | 21 |
| | 9 | 141 | 136 | 153 | 29 | 61 | 71 | 198 | 84 |
| | 12 | 49 | 5 | 5 | 204 | 23 | 78 | 60 | 82 |
| | 15 | 157 | 94 | 51 | 32 | 96 | 18 | 127 | 224 |
| 2 | 0 | 84 | 160 | 97 | 161 | 20 | 37 | 136 | 104 |
| | 2 | 149 | 160 | 78 | 21 | 132 | 135 | 13 | 220 |
| | 5 | 48 | 139 | 150 | 61 | 28 | 4 | 72 | 63 |
| | 9 | 0 | 166 | 10 | 170 | 110 | 121 | 47 | 206 |
| | 14 | 221 | 86 | 67 | 36 | 75 | 44 | 179 | 207 |
| | 16 | 38 | 35 | 90 | 17 | 59 | 96 | 9 | 138 |

For a fixed lifting size index, one non-0 position in a base matrix corresponds to one shifting value. For example, a shifting value corresponding to a 0^{th} row and a 0^{th} column in H_{BG} when the lifting size index is equal to 0 is 211, a shifting value corresponding to a 1^{st} row and a 6^{th} column in H_{BG} when the lifting size index is equal to 3 is 66, and a shifting value corresponding to a 2^{nd} row and a 9^{th} column in H_{BG} when the lifting size index is equal to 7 is 206.

It may be understood that, during LDPC encoding, a lifting size needs to be first determined, and then a corresponding shifting value is determined based on the selected lifting size to construct a check matrix. For example, the determined lifting size is 40, and a lifting size index corresponding to 40 in Table 1 is 2. In this case, the check matrix may be constructed based on shifting values in a column corresponding to the lifting size index equal to 2 in Table 2.

### 4. Column weight and row weight

For a column in a matrix, the column weight may refer to a quantity of non-zero elements included in the column. For a row in a matrix, the row weight may refer to a quantity of non-zero elements included in the row. It may be understood that the matrix in the descriptions about the row weight and the column weight is a check matrix H.

### 5. Structure of a check matrix

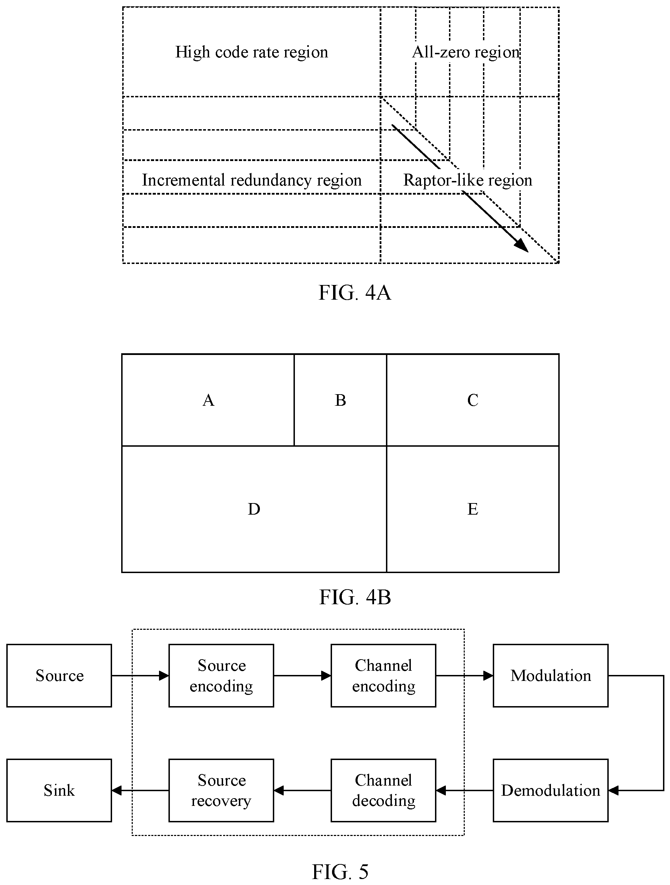

FIG. 4A and FIG. 4B are diagrams of structures of a check matrix.

As shown in FIG. 4A, the check matrix may include a high code rate region (high rate region), an all-zero region, an incremental redundancy region (incremental redundancy region), and a raptor-like region (raptor-like region). The high code rate region may include a part A and a part B shown in FIG. 4B. The part A corresponds to information bits (or referred to as information bits, system bits, or the like), and the part B is a square matrix and corresponds to core check bits (or referred to as core parity check bits). A core check may be a check corresponding to the highest code rate, or may be a check whose degree is greater than or equal to 2, or may be a check node corresponding to a set of rows with the highest row weight (the row weight is distinctly/significantly higher than that of another row). The all-zero region may correspond to a part C in FIG. 4B, and is an all-zero matrix. The incremental redundancy region (incremental redundancy region) may correspond to a part D in FIG. 4B. The raptor-like region may correspond to a part E in FIG. 4B, may be an identity matrix, and corresponds to a check bit of low code rate extension.

The check matrix of an LDPC code shown in FIG. 4A and FIG. 4B uses a "raptor-like" structure, and may be gradually expanded to a low code rate through a core matrix with a high code rate. During actual use, as shown in FIG. 4A, first X rows and first Y columns in the check matrix may be intercepted. In descending order of code rates, X and Y gradually increase, and a region in which the matrix is used also gradually expands.

It should be noted that the check matrix may be represented by an LDPC base matrix. Therefore, a structure of the LDPC base matrix is similar to the structure of the check matrix. Details are not described herein again.

### 6. Information column and check column

Columns in an LDPC base matrix include information columns and check columns.

The information columns correspond to information bits (or referred to as information bits, system bits, or the like), and are columns corresponding to the part A.

The check columns correspond to check bits (or parity check bits or the like), and may include core check columns and extended check columns. The core check columns are columns corresponding to the part B, and the extended check columns are columns corresponding to the part C or the part E. The extended check columns may also be referred to as raptor-like columns.

### 7. Information transmission procedure

FIG. 5 is a diagram of an information transmission procedure applicable to this application. As shown in FIG. 5, information is sent by a source, and after processing such as source encoding, channel encoding, modulation, air interface transmission, demodulation, channel decoding, and source recovery, the information arrives at a sink, so that transmission of the information from the source to the sink is completed. In FIG. 5, processing (including source encoding, channel encoding, modulation, and the like) shown at an upper layer is performed at a transmitter device, and processing (including demodulation, channel decoding, source recovery, and the like) shown at a lower layer is performed at a receiver device. Embodiments of this application mainly relate to source encoding, channel encoding, channel decoding, and source recovery shown in FIG. 5.

Currently, a decoding threshold and decoding complexity of a QC-LDPC code are mainly determined by a base graph (that is, a base matrix). A small-scale base matrix is greatly limited in supporting a degree distribution of the LDPC code, the decoding threshold cannot be optimal, and NR LDPC performance is severely degraded when a code rate is extremely high. The degree distribution of the LDPC code indicates a column weight distribution of a check matrix. In a possible implementation, the decoding threshold may be increased by expanding the base matrix. However, without the introduction of good orthogonality, a large-scale base matrix has a low degree of parallelism, and a hardware implementation is complex.

In view of this, this application provides a communication method based on an LDPC code and a communication apparatus, to effectively resolve the foregoing technical problem.

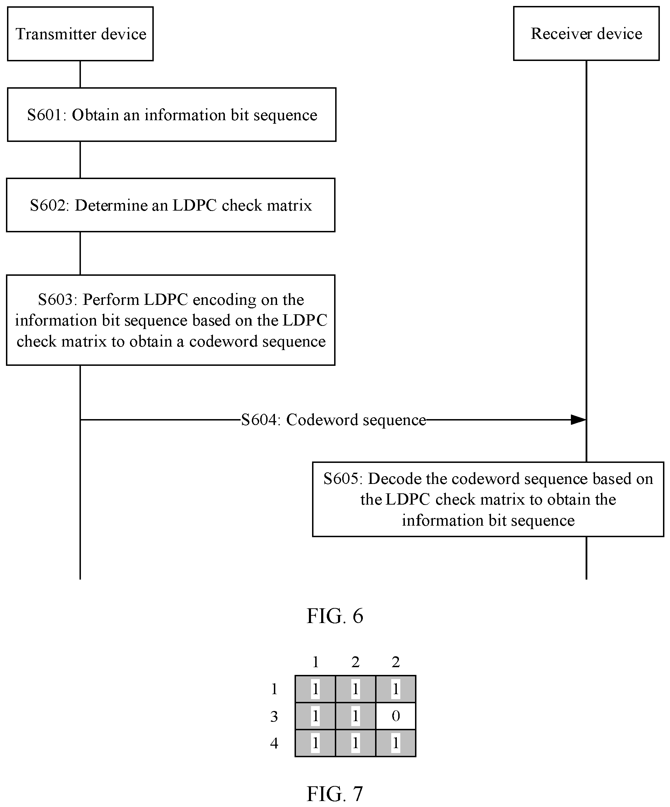

FIG. 6 is a schematic flowchart of a communication method 600 based on an LDPC code according to this application. The method includes the following steps.

It may be understood that the method 600 may be performed by a transmitter device and a receiver device. Unless otherwise specified, the "transmitter device" or the "receiver device" may be the transmitter device or the receiver device, or may be an apparatus that can support the transmitter device or the receiver device in implementing the function. For ease of description, the transmitter device and the receiver device are used for description below. The transmitter device may be a terminal device or a network device. The receiver device may be a terminal device or a network device.

S601: The transmitter device obtains an information bit sequence.

It may be understood that if the transmitter device needs to communicate with the receiver device, that is, the transmitter device needs to send a signal to the receiver device, the transmitter device needs to first obtain an information bit sequence corresponding to the signal to be sent to the receiver device.

That the transmitter device obtains the information bit sequence may mean that the transmitter device performs source encoding on a source symbol to generate the information bit sequence. Alternatively, that the transmitter device obtains the information bit sequence may mean that the transmitter device receives the information bit sequence from another communication apparatus. A manner of obtaining the information bit sequence is not limited in this application.

S602: The transmitter device determines an LDPC check matrix.

In a possible implementation, the LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, k corresponding to at least one 1 element in the base matrix is an integer greater than 1, and Z_{c} is an integer greater than 1. The following describes in detail a feature of each part used to determine the check matrix.

### (1) Base matrix

It may be understood that elements in the base matrix include 0 and 1, that is, each element is either 0 or 1.

Optionally, all rows of the base matrix and a column associated with each row may be stored in a table. When an associated column exists, it indicates that a value corresponding to such a position in the base matrix is 1; or when an associated column does not exist, it indicates that a value corresponding to such a position in the base matrix is 0. For example, a storage manner of the base matrix may be shown by first two columns in Table 3 and Table 4.

**Table 3**

| H_{BG} | | Shifting value | | | | | | | |
|---|---|---|---|---|---|---|---|---|---|
| Row index | Column index (edge) | Lifting size index | | | | | | | |
| | | 0 | 1 | 2 | 3 | 4 | 5 | 6 | 7 |
| 0 | 0 | 211 | 39 | 102 | 216 | 6 | 86 | 13 | 183 |
| | | 165 | 141 | 22 | 211 | 120 | 62 | 112 | 157 |
| | | 111 | 68 | 116 | 221 | 18 | 170 | 1 | 204 |
| | 1 | 243 | 174 | 98 | 127 | 123 | 94 | 194 | 73 |
| | | 8 | 34 | 142 | 114 | 88 | 26 | 64 | 48 |
| | | 209 | 66 | 79 | 203 | 50 | 63 | 125 | 53 |
| | 5 | 98 | 179 | 101 | 174 | 110 | 132 | 108 | 84 |
| | | 177 | 33 | 90 | 0 | 129 | 124 | 118 | 226 |
| | | 170 | 181 | 50 | 177 | 72 | 60 | 106 | 60 |
| | 8 | 205 | 188 | 73 | 66 | 18 | 117 | 113 | 21 |
| | | 141 | 136 | 153 | 29 | 61 | 71 | 198 | 84 |
| | | 49 | 5 | 5 | 204 | 23 | 78 | 60 | 82 |
| 1 | 0 | 157 | 94 | 51 | 32 | 96 | 18 | 127 | 224 |
| | | 84 | 160 | 97 | 161 | 20 | 37 | 136 | 104 |
| | | 149 | 160 | 78 | 21 | 132 | 135 | 13 | 220 |
| | 6 | 48 | 139 | 150 | 61 | 28 | 4 | 72 | 63 |
| | | 0 | 166 | 10 | 170 | 110 | 121 | 47 | 206 |
| | | 221 | 86 | 67 | 36 | 75 | 44 | 179 | 207 |
| | 9 | 38 | 35 | 90 | 17 | 59 | 96 | 9 | 138 |
| | | 117 | 38 | 53 | 58 | 119 | 141 | 77 | 98 |
| | | 54 | 161 | 159 | 196 | 138 | 150 | 58 | 206 |
| 2 | 2 | 138 | 99 | 18 | 111 | 6 | 11 | 202 | 80 |
| | | 1 | 28 | 27 | 213 | 80 | 44 | 29 | 30 |
| | | 18 | 165 | 10 | 182 | 115 | 103 | 53 | 60 |
| | 10 | 74 | 98 | 44 | 175 | 122 | 11 | 22 | 79 |
| | | 17 | 180 | 142 | 54 | 90 | 8 | 79 | 69 |
| | | 60 | 164 | 6 | 117 | 2 | 98 | 95 | 148 |
| | 11 | 91 | 117 | 115 | 81 | 52 | 13 | 58 | 121 |
| | | 43 | 75 | 65 | 19 | 21 | 164 | 82 | 16 |
| | | 111 | 91 | 26 | 20 | 125 | 50 | 6 | 123 |

### (2) Lifting size Z_{c}

For example, Z_{c} is a lifting size in the lifting size set shown in Table 1.

### (3) Shifting value corresponding to each 1 element in the base matrix

Optionally, the 1 element in the base matrix may correspond to a plurality of groups of shifting values, and the transmitter device may determine, based on Z_{c}, a group of shifting values to be used. For example, the 1 element in the base matrix has eight groups of shifting values shown in Table 3 (that is, one lifting size index corresponds to one group of shifting values). If the determined lifting size is 56, as a lifting size index corresponding to 56 in Table 1 is 3, the transmitter device determines to construct the check matrix by using shifting values in a column corresponding to the lifting size index equal to 3 in Table 3.

It may be understood that, if the group of shifting values to be used is determined based on Z_{c}, any shifting value in the group of shifting values is greater than or equal to 0 and less than or equal to Zₘₐₓ-1. Zₘₐₓ is a maximum lifting size in a group corresponding to Z_{c}, and each row in Table 1 corresponds to one group, that is, Zₘₐₓ is a maximum lifting size in the lifting size set to which Z_{c} belongs in Table 1. For example, if Z_{c} is 56, Zₘₐₓ is 224.

Optionally, each group of shifting values may be stored in the form in Table 1. To be specific, one row index, one column index, and one lifting size index correspond to a plurality of positions (there are three positions in Table 1), and one shifting value is stored at each position; or one row index, one column index, and one lifting size index in Table 1 correspond to one position, and a plurality of shifting values are stored at the one position. A storage form of the shifting value is not limited in this application. For example, one row index, one column index, and one lifting size index correspond to one position, and a plurality of shifting values stored at the one position may be written as (SV₁, SV₂, ...).

Optionally, an LDPC storage matrix may be defined in a protocol. The storage matrix indicates a base matrix and k shifting values corresponding to each 1 element in the base matrix. For example, a storage form of the LDPC storage matrix may be shown in Table 3.

Optionally, when k shifting values corresponding to a 1 element in the base matrix are greater than 1, a shifting value and a function that correspond to the 1 element may be stored in the storage matrix, and the other k-1 shifting values may be determined based on the stored shifting value and function. (4) Quantity k of shifting values corresponding to each 1 element: Based on the foregoing description, the quantity k of 1 elements in the base matrix is an integer greater than or equal to 1, and k corresponding to at least one 1 element in the base matrix is an integer greater than 1. It can be learned that each 1 element in the base matrix has a corresponding shifting value, and at least one 1 element corresponds to two or more shifting values. For example, when the lifting size index in Table 3 is equal to 3, shifting values corresponding to a 0^{th} row and a 0^{th} column of the base matrix are 216, 211, and 221.

Optionally, quantities k of shifting values corresponding to all 1 elements in an information column of the base matrix are equal to 2, 3, 4, or 6.

The lifting size Z_{c} and the k shifting values of each 1 element in the base matrix indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k Z_{c}×Z_{c} cyclic shift matrices (that is, the k shifting values are in one-to-one correspondence with the k Z_{c}×Z_{c} cyclic shift matrices).

The following describes a possible expansion process (or lifting process) of determining the check matrix based on the base matrix, the lifting size, and the shifting value.

Step 1: Before expansion, a first indicator associated with each row of the base matrix needs to be determined, for example, a first indicator associated with an i^{th} row is *α*(*i*); and a second indicator associated with each column of the base matrix needs to be determined, for example, a second indicator associated with a j^{th} column is *b*(*j*), where *α*(*i*) is an integer greater than or equal to 1, and *b*(*j*) is an integer greater than or equal to 1. Then, *α*(*i*) and *b*(*j*) corresponding to a 1 element are determined based on the row i and the column j in which the 1 element is located in the base matrix, where *α*(*i*) ∗ *b*(*j*) is equal to a quantity k of shifting values of the 1 element. For example, if *α*(*i*) corresponding to the 1 element is equal to 1 and *b*(*j*) corresponding to the 1 element is equal to 2, the quantity k of shifting values corresponding to the 1 element is equal to 2. For another example, if *α*(*i*) corresponding to the 1 element is equal to 1 and *b*(*j*) corresponding to the 1 element is equal to 3, the quantity k of shifting values corresponding to the 1 element is equal to 3. Then, the transmitter device constructs the check matrix based on *α*(*i*) and *b*(*j*) corresponding to each 1 element.

It may be understood that when all rows of the base matrix correspond to the same *α*(*i*), and all columns of the base matrix correspond to the same *b*(*i*), quantities of shifting values of all 1 elements in the base matrix are the same.

Optionally, the transmitter device may autonomously determine *α*(*i*) and *b*(*j*). For example, when quantities k of shifting values of all the 1 elements in the base matrix are the same, *α*(*i*) may be equal to 1 by default, so that *b*(*i*) is determined, that is, *b*(*i*) is equal to k. For example, when quantities k of shifting values of all the 1 elements in the base matrix are the same, b(*i*) may be equal to 1 by default, so that *a*(*i*) is determined, that is, *a*(*i*) is equal to k.

Optionally, the transmitter device may determine, based on first indication information, *α*(*i*) associated with each row of the base matrix, where the first indication information indicates *α*(*i*) associated with all rows of the base matrix; and determine, based on second indication information, *b*(*j*) associated with each column of the base matrix, where the second indication information indicates *b*(*j*) associated with all columns of the base matrix.

Optionally, the transmitter device may determine, based on first indication information and the quantity k of shifting values corresponding to the 1 element in the base matrix, *α*(*i*) associated with each row of the base matrix and *b*(*j*) associated with each column of the base matrix; or the transmitter device determines, based on second indication information and the quantity k of shifting values corresponding to the 1 element in the base matrix, *α*(*i*) associated with each row of the base matrix and *b*(*j*) associated with each column of the base matrix, where the second indication information indicates second indicators associated with all columns of the base matrix.

For example, the first indication information is a first sequence, and a length of the first sequence is the same as a total quantity of rows of the base matrix. For example, if the base matrix includes M rows, the first sequence is { *α*(0), *α*(1), *..., α*(*M -* 1)}, where *α*(0), *α*(1), ..., and *α*(*M -* 1) are first indicators associated with a 0^{th} row, a 1^{st} row, ..., and an (M-1)^{th} row respectively.

For example, the second indication information is a second sequence, and a length of the second sequence is the same as a total quantity of columns of the base matrix. For example, if the base matrix includes N columns, the first sequence is { *b*(0), *b*(*1*), *..., b*(*N -* 1)}, where *b(0), b*(1), ..., and *b*(*N -* 1) are second indicators associated with a 0^{th} column, a 1^{st} column, ..., and an (N-1)^{th} row respectively.

For example, the first sequence and the second sequence may be predetermined in a protocol. The first sequence and the second sequence are described by using an example. The base matrix is shown in FIG. 7, *α*(0), *α*(1), and *α*(2) corresponding to the 0^{th} row to the 2^{nd} row of the base matrix are respectively 1, 3, and 4, and *b*(*0*), *b*(1), and b(2) corresponding to the 0^{th} column to the 2^{nd} column of the base matrix are respectively 1, 2, and 2. In this case, the first sequence is {1, 3, 4}, and the second sequence is {1, 3, 5}. It may be understood that, in the base matrix, a 1 element in the 0^{th} row and the 0^{th} column corresponds to one shifting value, a 1 element in the 1^{st} row and the 1^{st} column corresponds to six shifting values, and a 1 element in the 2^{nd} row and the 1^{st} column corresponds to eight shifting values.

Step 2: Construct the check matrix based on the base matrix, the lifting size, the shifting value, *α*(*i*), and *b*(*j*). The following provides two possible expansion manners of constructing the check matrix.

### Expansion manner 1: segmented expansion manner

(1) First expansion phase: Replace a first element in the base matrix with an *α*(*i*1)×*b*(*j*1) all-1 matrix, and replace a second element in the base matrix with an *α*(*i*2)×*b*(*j*2) all-0 matrix, where the first element is a 1 element located in a row *i*1 and a column *j*1, and the second element is a 0 element located in a row *i*2 and a column *j*2.
(2) Second expansion phase: Replace each 1 in the *α*(*i*1) × *b*(*j*1) all-1 matrix corresponding to the first element with a Z_{c}×Z_{c} cyclic shift matrix, where *α*(*i*1)×*b*(*j*1) Z_{c}×Z_{c} cyclic shift matrices after the replacement are matrices obtained by cyclically shifting the Z_{c}×Z_{c} identity matrix based on *α*(*i*1)×*b*(*j*1) shifting values corresponding to the first element; and replace 0 in the *α*(*i*2)×*b*(*j*2) all-0 matrix with a Z_{c}×Z_{c} all-0 matrix to obtain the LDPC check matrix.

The expansion manner 1 is described by using an example with reference to Table 4. A base matrix determined based on first two columns in Table 4 is shown in Table 5. A third column in Table 4 represents a shifting value to be used when the base matrix shown in Table 5 is expanded. Each 1 element has k=3 shifting values. For example, the quantity k of shifting values corresponding to the first element in the base matrix is equal to *α*(*i*1) ∗ *b*(*j*1)=1×3, and Z_{c}=3.

**Table 4**

| Row index | Column index | Shifting value |
|---|---|---|
| 0 | 0 | 0 |
| | | 1 |
| | | 2 |
| | 1 | 0 |
| | | 0 |
| | | 0 |
| | 2 | 0 |
| | | 1 |
| | | 1 |
| 1 | 0 | 0 |
| | | 1 |
| | | 1 |
| | 1 | 0 |
| | | 2 |
| | | 1 |

**Table 5**

| | | |
|---|---|---|
| 1 | 1 | 1 |
| 1 | 1 | 0 |

In this case, based on the description of the expansion manner 1, first, each first element in the base matrix shown in Table 5 is expanded to a 1×3 all-1 matrix (that is, an all-1 matrix with one row and three columns), and each second element in the base matrix is expanded to a 1×3 all-0 matrix (that is, an all-0 matrix with one row and three columns). After the first expansion, a matrix shown in Table 6 is obtained.

**Table 6**

| | | | | | | | | |
|---|---|---|---|---|---|---|---|---|
| 1 | 1 | 1 | 1 | 1 | 1 | 1 | 1 | 1 |
| 1 | 1 | 1 | 1 | 1 | 1 | 0 | 0 | 0 |

Then, each 1 element in each 1×3 all-1 matrix in Table 6 is replaced with a Z_{c}×Z_{c} (that is, 3×3) cyclic shift matrix, where 1×3 Z_{c}×Z_{c} cyclic shift matrices obtained after the all-1 matrix of each first element is replaced are obtained by cyclically shifting the Z_{c}×Z_{c} identity matrix based on three shifting values of the first element; and each 0 element in each 1×3 all-0 matrix in Table 6 is replaced with a Z_{c}×Z_{c} all-0 matrix. In this case, a check matrix obtained after the second expansion is shown in Table 7.

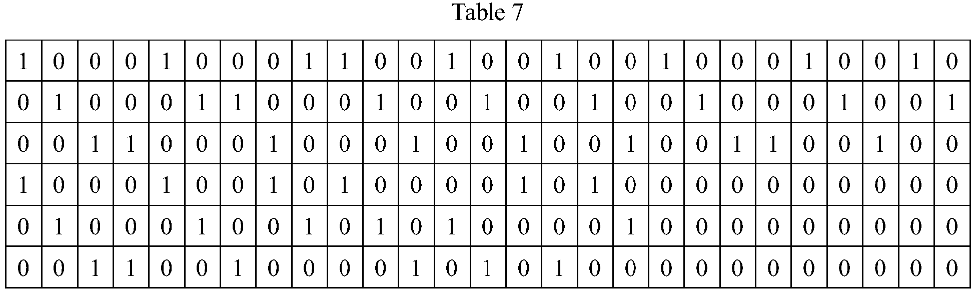

### Expansion manner 2: direct expansion manner

A first element in the base matrix is replaced with *α*(*i*1)×*b*(*j*1) Z_{c}×Z_{c} cyclic shift matrices, where the *α*(*i*1)×*b*(*j*1) Z_{c}×Z_{c} cyclic shift matrices are matrices obtained by cyclically shifting the Z_{c}×Z_{c} identity matrix based on *α*(*i*1)×*b*(*j*1) shifting values corresponding to the first element; and a second element in the base matrix is replaced with *α*(*i*2)×*b*(*j*2) Z_{c}×Z_{c} all-0 matrices to obtain the LDPC check matrix, where the first element is a 1 element located in a row *i*1 and a column *j*1, and the second element is a 0 element located in a row *i2* and a columnj2.

It may be understood that in this expansion manner, the *α*(*i*1)×*b*(*j*1) Z_{c}×Z_{c} cyclic shift matrices obtained by expanding the first element form one (*α*(*i*1)×Z_{c})×(*b*(*j*1)×Z_{c}) matrix. To be specific, the *α*(*i*1)×*b*(*j*1) Z_{c}×Z_{c} cyclic shift matrices are placed in a total of *a*(*j*1) rows in a manner in which *b*(*j*1) Z_{c}×Z_{c} cyclic shift matrices are placed in each row. Similarly, the *α*(*i*2) × *b(j2)* Z_{c}×Z_{c} all-0 matrices obtained by expanding the second element form one (*α*(*i*2) ×Z_{c})×(*b*(*j*2) ×Z_{c}) all-0 matrix. To be specific, the *α*(*i*2) × *b(j2)* Z_{c}×Z_{c} all-0 matrices obtained through expansion are placed in a total of *a*(*j*2) rows in a manner in which *b*(*j*2) Z_{c}×Z_{c} all-0 matrices are placed in each row.

It may be understood that, compared with the expansion manner 1, the expansion manner 2 may be considered as directly obtaining the check matrix through expansion without the first expansion phase. However, the check matrices finally obtained based on the two expansion manners are the same.

For example, in the foregoing expansion manner 1 and expansion manner 2, the *α*(*i*1) × *b*(*j*1) shifting values of the first element are in one-to-one correspondence with the *α*(*i*1) × *b*(*j*1) Z_{c}×Z_{c} cyclic shift matrices in an order of row-first and column-second, or the *α*(*i*1) × *b*(*j*1) shifting values of the first element are in one-to-one correspondence with the *α*(*i*1)×*b*(*j*1) Z_{c}×Z_{c} cyclic shift matrices in an order of column-first and row-second. For example, the first element corresponds to six shifting values (SV₁, SV₂, SV₃, SV₄, SV₅, SV₆), and *α*(*i*1)×*b*(*j*1) corresponding to the first element is equal to 2×3. In this case, the *α*(*i*1)×*b*(*j*1)=6 Z_{c}×Z_{c} cyclic shift matrices obtained by expanding the first element are placed in a total of two rows in a manner in which three Z_{c}×Z_{c} cyclic shift matrices are placed in each row. If the correspondence of row-first and column-second is used, shifting values corresponding to the six Z_{c}×Z_{c} cyclic shift matrices are $\left(\begin{matrix}{SV}_{1} , {SV}_{2} , {SV}_{3} \\ {SV}_{4} , {SV}_{5} , {SV}_{6}\end{matrix}\right)$. If the correspondence of column-first and row-second is used, shifting values corresponding to the six Z_{c}×Z_{c} cyclic shift matrices are $\left(\begin{matrix}{SV}_{1} , {SV}_{3} , {SV}_{5} \\ {SV}_{2} , {SV}_{4} , {SV}_{6}\end{matrix}\right)$.

The expansion manner 2 is described by using an example with reference to Table 4. A base matrix determined based on first two columns in Table 4 is shown in Table 5. A third column in Table 4 represents a shifting value to be used when the base matrix shown in Table 5 is expanded. Each 1 element has k=3 shifting values. For example, the quantity k of shifting values corresponding to the first element in the base matrix is equal to *α*(*i*1) * *b*(*j*1)=1×3, and Z_{c}=3.

Specifically, based on the expansion manner 2, each 1 element in the base matrix is directly replaced with 1×3 Z_{c}×Z_{c} cyclic shift matrices, where the 1×3 Z_{c}×Z_{c} cyclic shift matrices are matrices obtained by cyclically shifting the Z_{c}×Z_{c} identity matrix based on three shifting values corresponding to the corresponding first element; and the second element in the base matrix is replaced with 1×3 Z_{c}×Z_{c} all-0 matrices. An obtained LDPC check matrix is shown in Table 7.

It may be understood that, in the foregoing example, an example in which quantities of shifting values corresponding to all 1 elements in the base matrix are the same and *α*(*i*1) corresponding to the first element is equal to 1 is used for description. For example, if the quantities of shifting values corresponding to all the 1 elements in the base matrix are 12, and k=*α*(*i*1) * *b*(*j*1)=3×4, a manner of expanding the check matrix is the same, and there is only a need to replace k in the foregoing example with 12, replace *α*(*i*1) with 3, and replace *b*(*i*1) with 4. Details are not described herein.

Similarly, the foregoing expansion manner is also applicable to a scenario in which the quantities of shifting values corresponding to the 1 elements in the base matrix are different. As shown in Table 8, the quantities of shifting values corresponding to the 1 elements in the base matrix are different.

**Table 8**

| H_{BG} | | Shifting value | | | | | | | |
|---|---|---|---|---|---|---|---|---|---|
| Row index | Column index (edge) | Lifting size index | | | | | | | |
| | | 0 | 1 | 2 | 3 | 4 | 5 | 6 | 7 |
| 0 | 1 | 243 | 174 | 98 | 127 | 123 | 94 | 194 | 73 |
| | | 8 | 34 | 142 | 114 | 88 | 26 | 64 | 48 |
| | 5 | 209 | 66 | 79 | 203 | 50 | 63 | 125 | 53 |
| | | 98 | 179 | 101 | 174 | 110 | 132 | 108 | 84 |
| | | 177 | 33 | 90 | 0 | 129 | 124 | 118 | 226 |
| | 8 | 170 | 181 | 50 | 177 | 72 | 60 | 106 | 60 |
| | | 205 | 188 | 73 | 66 | 18 | 117 | 113 | 21 |
| | 0 | 141 | 136 | 153 | 29 | 61 | 71 | 198 | 84 |
| | | 49 | 5 | 5 | 204 | 23 | 78 | 60 | 82 |
| | | 157 | 94 | 51 | 32 | 96 | 18 | 127 | 224 |
| 1 | 6 | 84 | 160 | 97 | 161 | 20 | 37 | 136 | 104 |
| | | 149 | 160 | 78 | 21 | 132 | 135 | 13 | 220 |
| | | 48 | 139 | 150 | 61 | 28 | 4 | 72 | 63 |
| | 9 | 0 | 166 | 10 | 170 | 110 | 121 | 47 | 206 |
| | | 221 | 86 | 67 | 36 | 75 | 44 | 179 | 207 |
| | | 38 | 35 | 90 | 17 | 59 | 96 | 9 | 138 |
| | 2 | 117 | 38 | 53 | 58 | 119 | 141 | 77 | 98 |
| | | 54 | 161 | 159 | 196 | 138 | 150 | 58 | 206 |
| 2 | 10 | 138 | 99 | 18 | 111 | 6 | 11 | 202 | 80 |
| | | 1 | 28 | 27 | 213 | 80 | 44 | 29 | 30 |
| | | 18 | 165 | 10 | 182 | 115 | 103 | 53 | 60 |
| | 11 | 74 | 98 | 44 | 175 | 122 | 11 | 22 | 79 |
| | | 17 | 180 | 142 | 54 | 90 | 8 | 79 | 69 |
| | | 60 | 164 | 6 | 117 | 2 | 98 | 95 | 148 |
| | 12 | 91 | 117 | 115 | 81 | 52 | 13 | 58 | 121 |
| | | 43 | 75 | 65 | 19 | 21 | 164 | 82 | 16 |
| | | 111 | 91 | 26 | 20 | 125 | 50 | 6 | 123 |

For ease of understanding, the following uses an example to describe how to obtain the check matrix through expansion in the scenario in which the quantities of shifting values corresponding to the 1 elements in the base matrix are different.

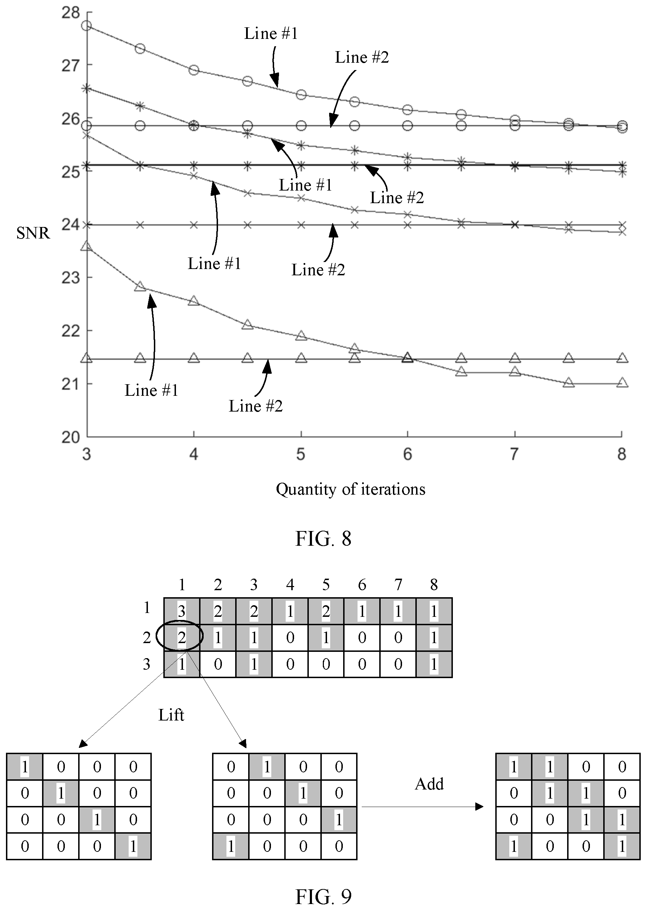

An example is provided for description with reference to FIG. 9. A base matrix determined based on first two columns in Table 9 is shown in Table 5, and a third column in Table 4 represents a shifting value to be used when the base matrix shown in Table 10 is expanded. In the base matrix, a 1 element in a 0^{th} row and a 0^{th} column corresponds to one shifting value, a 1 element in a 1^{st} row and the 0^{th} column corresponds to two shifting values, and a 1 element in the 1^{st} row and a 1^{st} column corresponds to four shifting values. For example, *α*(0) corresponding to the 0^{th} row in the base matrix is equal to 1, *α*(1) corresponding to the 1^{st} row is equal to 2, *b(0)* corresponding to the 0^{th} column is equal to 1, and b(1) corresponding to the 1^{st} row in the base matrix is equal to 2. In this case, the 1 element in the 0^{th} row and the 0^{th} column corresponds to one shifting value quantity equal to *α*(0) * *b(0),* the 1 element in the 1^{st} row and the 0^{th} column corresponds to one shifting value quantity equal to *α*(1) * *b*(0), the 1 element in the 1^{st} row and the 1^{st} column corresponds to one shifting value quantity equal to *α*(1) * *b*(1), and Z_{c}=3.

**Table 9**

| Row index | Column index | Shifting value |
|---|---|---|
| 0 | 0 | 0 |
| | 0 | 0 |
| | | 1 |
| 1 | 1 | 0 |
| | | 2 |
| | | 1 |
| | | 2 |

**Table 10**

| | |
|---|---|
| 1 | 0 |
| 1 | 1 |

For example, the expansion process of determining the check matrix is described herein based on the expansion manner 1. First, each first element in the base matrix shown in Table 10 is expanded to an *α*(*i*1) * *b*(*j*1) all-1 matrix, and each second element in the base matrix is expanded to an *α*(*i*2) * *b(j2)* all-0 matrix. The first element is a 1 element located in a row *i*1 and a column j1 in the base matrix, and the second element is a 0 element located in a row i2 and a column *j*2 in the base matrix. After the first expansion, a matrix shown in Table 11 is obtained.

**Table 11**

| | | |
|---|---|---|
| 1 | 0 | 0 |
| 1 | 1 | 1 |
| 1 | 1 | 1 |

Then, each 1 in the all-1 matrix corresponding to each first element in Table 11 is replaced with a Z_{c}×Z_{c} (that is, 3×3) cyclic shift matrix, where *α*(*i*1) * *b*(*j*1) corresponding Z_{c}×Z_{c} cyclic shift matrices obtained after the all-1 matrix corresponding to each first element is replaced are obtained by cyclically shifting the Z_{c}×Z_{c} identity matrix based on *α*(*i*1) * *b*(*j*1) shifting values of the first element (in Table 12, for example, k shifting values of the first element correspond to k expanded cyclic shift matrices in a manner of row-first and column-second); and each 0 element in the all-0 matrix corresponding to each second element in Table 11 is replaced with a Z_{c}×Z_{c} (that is, 3×3) all-0 matrix. In this case, a check matrix obtained through the second expansion is shown in Table 12.

**Table 12**

| | | | | | | | | |
|---|---|---|---|---|---|---|---|---|
| 1 | 0 | 0 | 0 | 0 | 0 | 0 | 0 | 0 |
| 0 | 1 | 0 | 0 | 0 | 0 | 0 | 0 | 0 |
| 0 | 0 | 1 | 0 | 0 | 0 | 0 | 0 | 0 |
| 1 | 0 | 0 | 1 | 0 | 0 | 0 | 0 | 1 |
| 0 | 1 | 0 | 0 | 1 | 0 | 1 | 0 | 0 |
| 0 | 0 | 1 | 0 | 0 | 1 | 0 | 1 | 0 |
| 0 | 1 | 0 | 0 | 1 | 0 | 0 | 0 | 1 |
| 0 | 0 | 1 | 0 | 0 | 1 | 1 | 0 | 0 |
| 1 | 0 | 0 | 1 | 0 | 0 | 0 | 1 | 0 |

The foregoing manner of determining the LDPC check matrix is applicable to the scenario in which the quantities of shifting values corresponding to the 1 elements in the base matrix are different. However, when the quantities of shifting values are different, a decoding threshold cannot be optimal, and actual performance is degraded. Therefore, this application provides another implementation. When the quantities of shifting values corresponding to the 1 elements in the base matrix are different, the quantities of shifting values corresponding to all the 1 elements may be supplemented to a same quantity, and then expansion is performed to obtain the check matrix. The following describes the implementation in detail.

In another possible implementation, the LDPC check matrix is determined based on an LDPC base matrix, a lifting size Z_{c}, a shifting value corresponding to each 1 element in the base matrix, and a quantity of shifting values corresponding to each 1 element, the quantity of shifting values corresponding to each 1 element is k, k is an integer greater than 1, k shifting values corresponding to at least one 1 element in the base matrix include at least one first-type shifting value and at least one second-type shifting value, all k shifting values corresponding to a remaining 1 element other than the at least one 1 element in the base matrix are first-type shifting values, the first-type shifting value is greater than or equal to 0 and less than or equal to Zₘₐₓ-1, the second-type shifting value is not equal to the first-type shifting value, Zₘₐₓ is a maximum lifting size in a group corresponding to Z_{c}, and Z_{c} is an integer greater than 1. The following describes in detail a feature of each part used to determine the check matrix.

For (1) the base matrix and (2) the lifting size, refer to the descriptions in the first implementation. Details are not described herein again.

### (3) Shifting value corresponding to each 1 element in the base matrix

Optionally, the 1 element in the base matrix may correspond to a plurality of groups of shifting values, and the transmitter device may determine, based on Z_{c}, a group of shifting values to be used. For a determining manner, refer to the foregoing descriptions. Details are not described herein again.

For example, the second-type shifting value is equal to -1. As shown in Table 13, the 1 element in the base matrix corresponds to eight groups of shifting values (that is, one lifting size index corresponds to one group of shifting values). For example, when the lifting size index in Table 13 is equal to 3, shifting values corresponding to a 0^{th} row and a 0^{th} column of the base matrix are -1, 211, and 221, where 211 and 221 are first-type shifting values, and -1 is a second-type shifting value.

**Table 13**

| H_{BG} | | Shifting value | | | | | | | |
|---|---|---|---|---|---|---|---|---|---|
| Row index | Column index (edge) | Lifting size index | | | | | | | |
| | | 0 | 1 | 2 | 3 | 4 | 5 | 6 | 7 |
| 0 | 0 | -1 | -1 | -1 | -1 | -1 | -1 | -1 | -1 |
| | | 165 | 141 | 22 | 211 | 120 | 62 | 112 | 157 |
| | | 111 | 68 | 116 | 221 | 18 | 170 | 1 | 204 |
| | 1 | 243 | 174 | 98 | 127 | 123 | 94 | 194 | 73 |
| | | 8 | 34 | 142 | 114 | 88 | 26 | 64 | 48 |
| | | 209 | 66 | 79 | 203 | 50 | 63 | 125 | 53 |
| | 5 | -1 | -1 | -1 | -1 | -1 | -1 | -1 | -1 |
| | | 177 | 33 | 90 | 0 | 129 | 124 | 118 | 226 |
| | | 170 | 181 | 50 | 177 | 72 | 60 | 106 | 60 |
| | 8 | 205 | 188 | 73 | 66 | 18 | 117 | 113 | 21 |
| | | 141 | 136 | 153 | 29 | 61 | 71 | 198 | 84 |
| | | 49 | 5 | 5 | 204 | 23 | 78 | 60 | 82 |
| 1 | 0 | 157 | 94 | 51 | 32 | 96 | 18 | 127 | 224 |
| | | 84 | 160 | 97 | 161 | 20 | 37 | 136 | 104 |
| | | 149 | 160 | 78 | 21 | 132 | 135 | 13 | 220 |
| | 6 | 48 | 139 | 150 | 61 | 28 | 4 | 72 | 63 |
| | | 0 | 166 | 10 | 170 | 110 | 121 | 47 | 206 |
| | | 221 | 86 | 67 | 36 | 75 | 44 | 179 | 207 |
| | 9 | 38 | 35 | 90 | 17 | 59 | 96 | 9 | 138 |
| | | -1 | -1 | -1 | -1 | -1 | -1 | -1 | -1 |
| | | 54 | 161 | 159 | 196 | 138 | 150 | 58 | 206 |
| 2 | 2 | 138 | 99 | 18 | 111 | 6 | 11 | 202 | 80 |
| | | 1 | 28 | 27 | 213 | 80 | 44 | 29 | 30 |
| | | 18 | 165 | 10 | 182 | 115 | 103 | 53 | 60 |
| | 10 | 74 | 98 | 44 | 175 | 122 | 11 | 22 | 79 |
| | | 17 | 180 | 142 | 54 | 90 | 8 | 79 | 69 |
| | | -1 | -1 | -1 | -1 | -1 | -1 | -1 | -1 |
| | 11 | 91 | 117 | 115 | 81 | 52 | 13 | 58 | 121 |
| | | 43 | 75 | 65 | 19 | 21 | 164 | 82 | 16 |
| | | 111 | 91 | 26 | 20 | 125 | 50 | 6 | 123 |

### (4) Quantity k of shifting values corresponding to each 1 element

Based on the foregoing description, the quantity of shifting values corresponding to each 1 element is k, k is an integer greater than 1, k shifting values corresponding to at least one 1 element in the base matrix include at least one first-type shifting value and at least one second-type shifting value, and all k shifting values corresponding to a remaining 1 element other than the at least one 1 element in the base matrix are first-type shifting values. It can be learned that each 1 element in the base matrix corresponds to a same quantity of shifting values, and k shifting values corresponding to a part of 1 elements include a second-type shifting value.

Optionally, k is equal to 2, 3, 4, or 6.

Z_{c} and the k shifting values of each 1 element indicate replacement of the corresponding 1 element with k1 Z_{c}×Z_{c} cyclic shift matrices and k2 Z_{c}×Z_{c} all-0 matrices, k1 and k2 are respectively a quantity of first-type shifting values and a quantity of second-type shifting values in the k shifting values, a sum of k1 and k2 is equal to k, the k1 Z_{c}×Z_{c} cyclic shift matrices are obtained by separately cyclically shifting a Z_{c}×Z_{c} identity matrix, and the k1 first-type shifting values are quantities of cyclic shifts corresponding to the k1 Z_{c}×Z_{c} cyclic shift matrices.

It may be understood that k2 may be equal to 0. When k2=0, it indicates that all the k shifting values of the 1 element are first-type shifting values.

It may be further understood that, a main difference from the first implementation lies in the following: In this implementation, k shifting values corresponding to a part of 1 elements include a second-type shifting value. When the second-type shifting value exists, an expansion manner corresponding to the 1 element is different from the expansion manner of the 1 element in the first implementation.

The following describes a possible expansion process of determining the check matrix based on the base matrix, the lifting size, and the shifting value in this implementation.

Step 1: Before expansion, a first indicator *α* associated with any row of the base matrix and a second indicator *b* associated with any column of the base matrix need to be determined, where *α* is an integer greater than or equal to 1, and *b* is an integer greater than or equal to 1. It may be understood that a quantity k of shifting values of any 1 element in the base matrix is equal to *α*(*i*) ∗ *b*(*j*). Then, the transmitter device constructs the check matrix based on *α* and *b* corresponding to the 1 element.

For a manner of determining the first indicator *α* and the second indicator *b*, refer to the descriptions in the first implementation. Details are not described herein again.

Step 2: Construct the check matrix based on the base matrix, the lifting size, the shifting value, *α*, and *b*. The following provides two possible expansion manners of constructing the check matrix.

### Expansion manner 1: segmented expansion manner

(1) First expansion phase: Replace a 1 element in the base matrix with an *α*×*b* matrix, where k shifting values corresponding to the 1 element in the base matrix are in one-to-one correspondence with positions of k elements in the *α* × *b* matrix, and if a shifting value corresponding to a first position in the *α*×*b* matrix is the first-type shifting value, an element corresponding to the first position is 1, or if a shifting value corresponding to the first position is the second-type shifting value, an element corresponding to the first position is 0; and replace each 0 element in the base matrix with an *α*×*b* all-0 matrix.
(2) Second expansion phase: Replace each 1 in the *α*×*b* matrix with a Z_{c}×Z_{c} cyclic shift matrix, where the cyclic shift matrix is a matrix obtained by cyclically shifting the Z_{c}×Z_{c} identity matrix based on a shifting value corresponding to a position of each 1 in the *α*×*b* matrix; replace each 0 in the *α*×*b* matrix with a Z_{c}×Z_{c} all-0 matrix; and replace each 0 in the *α*×*b* all-0 matrix with a Z_{c}×Z_{c} all-0 matrix to obtain the LDPC check matrix.

The expansion manner 1 is described by using an example with reference to Table 14. A base matrix determined based on first two columns in Table 14 is shown in Table 15. A third column in Table 14 represents a shifting value to be used when the base matrix shown in Table 15 is expanded. Each 1 element has k=3 shifting values. For example, the quantity k of shifting values corresponding to the 1 element in the base matrix is equal to *α* * *b*=1×3, and Z_{c}=3.

**Table 14**

| Row index | Column index | Shifting value |
|---|---|---|
| | 0 | -1 |
| | | 1 |
| | | 2 |
| | 1 | 0 |
| 0 | | 0 |
| | | 0 |
| | 2 | -1 |
| | | 1 |
| | | 1 |
| | 0 | 0 |
| | | 1 |
| 1 | | 1 |
| | 1 | 0 |
| | | -1 |
| | | 1 |

**Table 15**

| | | |
|---|---|---|
| 1 | 1 | 1 |
| 1 | 1 | 0 |

In this case, based on the description of the expansion manner 1, first, each 1 element in the base matrix shown in Table 15 is expanded to a corresponding 1×3 matrix (that is, a matrix with one row and three columns). A 1 example in a 0^{th} row and a 0^{th} column of the base matrix in Table 15 is used as an example. Three shifting values corresponding to the 1 element are -1, 1, and 2, and elements in a 1×3 matrix obtained by expanding the 1 element are 0, 1, and 1 respectively. In addition, each 0 element in the base matrix is expanded to a 1×3 all-0 matrix (that is, an all-0 matrix with one row and three columns). After the first expansion, a matrix shown in Table 16 is obtained.

**Table 16**

| | | | | | | | | |
|---|---|---|---|---|---|---|---|---|
| 0 | 1 | 1 | 1 | 1 | 1 | 0 | 1 | 1 |
| 1 | 1 | 1 | 1 | 0 | 1 | 0 | 0 | 0 |

Then, each 1 element in each 1×3 matrix in Table 16 is replaced with a Z_{c}×Z_{c} (that is, 3×3) cyclic shift matrix based on a corresponding shifting value, each 0 element is replaced with a Z_{c}×Z_{c} (that is, 3×3) all-0 matrix, and each 0 element in each 1×3 all-0 matrix in Table 16 is replaced with a Z_{c}×Z_{c} all-0 matrix. A check matrix obtained through the second expansion is shown in Table 17.

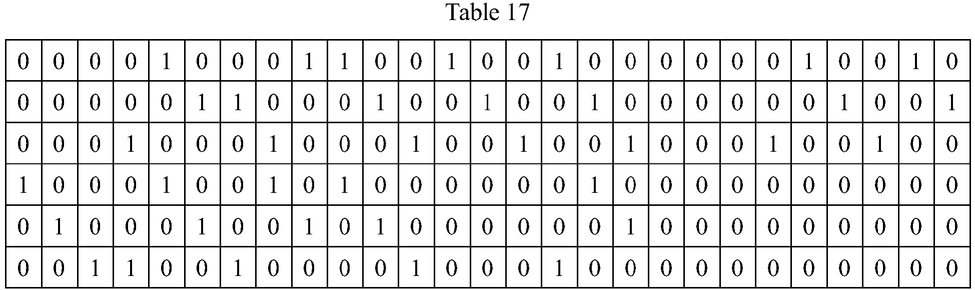

### Expansion manner 2: direct expansion manner

A 1 element in the base matrix is replaced with k1 Z_{c}×Z_{c} cyclic shift matrices and k2 Z_{c}×Z_{c} all-0 matrices, where the k1 Z_{c}×Z_{c} cyclic shift matrices are matrices obtained by cyclically shifting the Z_{c}×Z_{c} identity matrix based on k1 shifting values corresponding to the 1 element; and a 0 element in the base matrix is replaced with *α* * *b* Z_{c}×Z_{c} all-0 matrices to obtain the LDPC check matrix.

It may be understood that, in this implementation, the k1 Z_{c}×Z_{c} cyclic shift matrices and the k2 Z_{c}×Z_{c} all-0 matrices corresponding to the 1 element form one (*α*×Z_{c})×(*b*×Z_{c}) matrix. To be specific, the k1 cyclic shift matrices and the k2 all-0 matrices are placed in a total of *a* rows in a manner in which *b* matrices are placed in each row. Similarly, the *α* * *b* Z_{c}×Z_{c} all-0 matrices corresponding to the 0 element form one (*α*×Z_{c})×(*b*×Z_{c}) all-0 matrix. To be specific, the *α* * *b* Z_{c}×Z_{c} all-0 matrices obtained through expansion are placed in a total of *a* rows in a manner in which *b* Z_{c}×Z_{c} all-0 matrices are placed in each row.

It may be understood that, compared with the expansion manner 1, the expansion manner 2 may be considered as directly obtaining the check matrix through expansion without the first expansion phase. However, the check matrices finally obtained based on the two expansion manners are the same. Examples are not described herein again.

For a correspondence between the k Z_{c}×Z_{c} matrices obtained by expanding the 1 element and the k shifting values of the 1 element, refer to the descriptions in the first implementation. Details are not described herein again.

S603: The transmitter device encodes the information bit sequence based on the LDPC check matrix to obtain a codeword sequence.

S604: The transmitter device sends the codeword sequence to the receiver device. Correspondingly, the receiver device receives the codeword sequence from the transmitter device.

It should be noted that because a channel noise signal may be introduced in a process of transmitting the codeword sequence, the LDPC codeword sequence output or sent by the transmitter device may be different from the LDPC codeword sequence received by the receiver device.

S605: The receiver device decodes the codeword sequence based on the LDPC check matrix to obtain the information bit sequence.

The LDC check matrix based on which the receiver device performs decoding is the same as the LDPC check matrix based on which the transmitter device performs encoding. For a specific manner in which the receiver device determines the LDPC check matrix, refer to the descriptions on the transmitter device side. Details are not described herein again.

In the foregoing technical solution, a plurality of shifting values are configured for the 1 element in the base matrix, and the corresponding 1 element is expanded to a plurality of cyclic shift matrices based on the plurality of shifting values. Compared with an expansion solution in which the 1 element in the base matrix corresponds to one shifting value, in this solution, the check matrix obtained through expansion supports a larger column weight, and has a better decoding threshold. In addition, a scale of the base matrix does not need to be expanded on the basis of optimizing the decoding threshold, thereby reducing hardware implementation complexity.

FIG. 8 is a diagram of performance simulation for an LDPC code proposed based on this application and an LDPC code based on BG1. In FIG. 8, a horizontal axis represents a quantity of iterations, and a vertical axis represents a signal-to-noise ratio (signal-to-noise ratio, SNR) when a block error rate (block error rate, BLER) is 10⁻².

In FIG. 8, throughput efficiency comparison is performed based on performance alignment corresponding to BG1 by using performance of the LDPC code proposed in this application as a reference. As shown in FIG. 8, four lines #1 and four lines #2 are included. A line #1 and a line #2 that have a same shape correspond to one group of simulation results. Code rates used in the four groups of simulation diagrams are 44/47, 11/12, 7/8, and 3/4 respectively from top to bottom. The line #2 represents performance that can be achieved by the LDPC code proposed in this application after four iterations, and the line #1 represents performance that can be achieved based on BG1 of 5G with respect to the quantity of iterations corresponding to the horizontal coordinate. It can be learned that performance of the LDPC code proposed in this application at the four code rates is close to performance based on BG1 in 8, 7, 7, and 6 iterations respectively.

For a QC block parallel decoding architecture, a throughput *Throughput* is calculated as follows: $Throughput = \frac{{N}_{ldpc} ∗ {N}_{frame} ∗ {f}_{clk}}{{N}_{iteration} ∗ {N}_{Zc} ∗ {C}_{layer}}$

*N_{ldpc}* is a code length, *N_{frame}* is a quantity of packets decoded at the same time, *f_{clk}* is an operating frequency, *Nᵢₜₑᵣₐₜᵢₒₙ* is a quantity of decoding iterations, *N_{Zc}* is a quantity of QC blocks using a decoding matrix, and *C_{layer}* is a quantity of decoding clocks of a decoding row. A part that mainly affects the throughput is *N_{Zc},* that is, a non-0 quantity of a decoding matrix in one decoding iteration process.

Therefore, based on hardware evaluation, at different code rates, the LDPC code proposed in this application has a final throughput gain of more than two times compared with BG1.

Currently, there is further a multi-edge (multi-edge, ME) QC-LDPC code. Each 1 element in a base matrix corresponding to the multi-edge LDPC code also corresponds to a plurality of shifting values. However, an expansion manner of the multi-edge LDPC code is different from the expansion manner proposed in this application. The following describes the expansion manner of the multi-edge LDPC code with reference to FIG. 9.

FIG. 9 is a diagram of a multi-edge LDPC code. In the current multi-edge LDPC code, because an element in each base matrix may be an integer greater than or equal to 2, it indicates that such a position may be expanded to a plurality of cyclic shift matrices, which are further added to obtain an LDPC check matrix.

In this application, a quantity of multi-edges is a sum of positions at which element values in the base matrix are greater than or equal to 2. To be specific, as shown in FIG. 9, there are a total of five positions that have multi-edges: the 1^{st} row and the 1^{st} column, the 1^{st} row and the 2^{nd} column, the 1^{st} row and the 3^{rd} column, the 1^{st} row and the 5^{th} column, and the 2^{nd} row and the 1^{st} column. In other words, a quantity of multi-edges included in the base matrix shown in FIG. 9 is 5.

In this application, a multiplicity of a multi-edge is a specific value of a base matrix at a position. As shown in FIG. 9, a multiplicity of the multi-edge in the 1^{st} column and the 1^{st} row is 3, a multiplicity of the multi-edge in the 1^{st} column and the 2^{nd} row is 2, a multiplicity of the multi-edge in the 2^{nd} column and the 1^{st} row is 2, a multiplicity of the multi-edge in the 3^{rd} column and the 1^{st} row is 2, and a multiplicity of the multi-edge in the 5^{th} column and the 1^{st} row is 2. In the multi-edge LDPC code shown in FIG. 9, the maximum multiplicity among the foregoing multi-edge multiplicities is 3.

It may be understood that the multi-edge QC-LDPC code has larger degree distribution design space compared with a single-edge QC-LDPC code (elements in a base matrix corresponding to the single-edge QC-LDPC code include 0 and 1, and the 1 element corresponds to one shifting value). Currently, a design objective of the LDPC code is usually to ensure an optimal decoding threshold. However, the density evolution theory determines a column weight distribution, and the column weight distribution is a main factor that affects the decoding threshold. Therefore, a degree distribution of the LDPC code is a hot topic in research on encoding construction. Certainly, the multi-edge LDPC has a same matrix size as the single-edge LDPC, but supports a larger column weight. In other words, the multi-edge LDPC has a better decoding threshold. However, in a current wireless communication system, because there is an association relationship within each QC block in the multi-edge LDPC code, the multi-edge LDPC code cannot be read, computed, and stored in parallel, and has disadvantages such as a high latency, low hardware utilization, and unbalanced hardware utilization, thereby affecting decoding efficiency and performance of the LDPC code. In the method provided in this application, a plurality of shifting values are configured for a 1 element in a base matrix, so that a problem of a limited degree distribution and small design space of single-edge LDPC can be resolved. In addition, in the expansion manner provided in this application, orthogonality can be maintained, so that hardware decoding complexity is not increased compared with that of the single-edge QC-LDPC code, and is greatly reduced compared with that of the multi-edge QC-LDPC code.

Optionally, in this application, a generator matrix may be first determined, and LDPC encoding is performed on an information bit sequence based on the generator matrix. An expansion manner of determining the generator matrix is the same as the expansion manner provided in this application. Details are not described herein.

It may be understood that the steps in the foregoing accompanying drawings are merely examples for description, and are not strictly limited. In addition, sequence numbers of the foregoing processes do not mean a sequence of execution. The sequence of execution of the processes should be determined according to functions and internal logic of the processes, and should not constitute any limitation on an implementation process of embodiments of this application.

It may be further understood that some optional features in embodiments of this application may be independent of other features in some scenarios, or may be combined with other features in some scenarios. This is not limited.

It may be further understood that, in the foregoing method embodiments, the method and the operation implemented by the device (for example, the transmitter device or the receiver device) may also be implemented by a component (for example, a chip or a circuit) of the device. This is not limited.

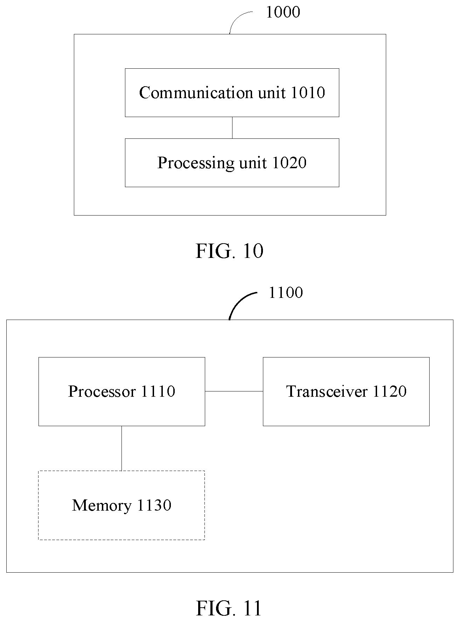

The foregoing describes in detail method embodiments provided in this application with reference to FIG. 1 to FIG. 9. The following describes apparatus embodiments of this application with reference to FIG. 10 and FIG. 11. It may be understood that, to implement functions in the foregoing embodiments, apparatuses in FIG. 10 and FIG. 11 include corresponding hardware structures and/or software modules for performing the functions. A person skilled in the art should be easily aware that, in combination with the units and the method steps in the examples described in embodiments disclosed in this application, this application can be implemented by using hardware or a combination of hardware and computer software. It may be understood that the technical features described in the method embodiments are also applicable to the following apparatus embodiments.

FIG. 10 and FIG. 11 are diagrams of structures of possible apparatuses according to embodiments of this application. These apparatuses may be configured to implement a function of the transmitter device or the receiver device in the foregoing method embodiments. Therefore, beneficial effects of the foregoing method embodiments can also be achieved.

FIG. 10 is a block diagram of a communication apparatus 1000 according to an embodiment of this application. As shown in FIG. 10, the apparatus 1000 may include a communication unit 1010 and a processing unit 1020. The communication unit 1010 may communicate with the outside, and the processing unit 1020 is configured to process data. The communication unit 1010 may also be referred to as a communication interface or a transceiver unit.

In a possible design, the apparatus 1000 may implement the steps or procedures performed by the transmitter device in the foregoing method embodiments. The processing unit 1020 is configured to perform processing-related operations of the transmitter device in the foregoing method embodiments, and the communication unit 1010 is configured to perform sending-related operations of the transmitter device in the foregoing method embodiments.

In another possible design, the apparatus 1000 may implement the steps or procedures performed by the receiver device in the foregoing method embodiments. The communication unit 1010 is configured to perform receiving-related operations of the receiver device in the foregoing method embodiments, and the processing unit 1020 is configured to perform processing-related operations of the receiver device in the foregoing method embodiments.

It may be understood that the apparatus 1000 herein is embodied in a form of a functional unit. The term "unit" herein may refer to an application-specific integrated circuit (application-specific integrated circuit, ASIC), an electronic circuit, a memory and a processor (such as a shared processor, a dedicated processor, or a group of processors) configured to execute one or more software or firmware programs, a combined logic circuit, and/or another suitable component that supports the described function. In an optional example, a person skilled in the art may understand that the apparatus 1000 may be specifically the transmitter device in the foregoing embodiments, and may be configured to perform procedures and/or steps corresponding to the transmitter device in the foregoing method embodiments; or the apparatus 1000 may be specifically the receiver device in the foregoing embodiments, and may be configured to perform procedures and/or steps corresponding to the receiver device in the foregoing method embodiments. To avoid repetition, details are not described herein again.

The apparatus 1000 in the foregoing solutions has a function of implementing corresponding steps performed by the transmitter device in the foregoing methods, or the apparatus 1000 in the foregoing solutions has a function of implementing corresponding steps performed by the receiver device in the foregoing methods. The function may be implemented by using hardware, or may be implemented by using hardware executing corresponding software. The hardware or software includes one or more modules corresponding to the foregoing function. For example, the communication unit may be replaced with a transceiver (for example, a sending unit in the communication unit may be replaced with a transmitter, and a receiving unit in the communication unit may be replaced with a receiver), and another unit such as the processing unit may be replaced with a processor, to separately perform sending and receiving operations and related processing operations in the method embodiments.

In addition, the communication unit may alternatively be a transceiver circuit (for example, the transceiver circuit may include a receiver circuit and a transmitter circuit), and the processing unit may be a processing circuit. In embodiments of this application, the apparatus in FIG. 10 may be the receiver device or the transmitter device in the foregoing embodiments, or may be a chip or a chip system, for example, a system on chip (system on chip, SoC). The communication unit may be an input/output circuit or a communication interface. The processing unit is a processor, a microprocessor, or an integrated circuit integrated on the chip. This is not limited herein.

FIG. 11 is a block diagram of a communication apparatus 1100 according to an embodiment of this application. The apparatus 1100 includes a processor 1110 and a transceiver 1120. The processor 1110 and the transceiver 1120 communicate with each other through an internal connection path. The processor 1110 is configured to execute instructions, to control the transceiver 1120 to send a signal and/or receive a signal.

Optionally, the apparatus 1100 may further include a memory 1130. The memory 1130 communicates with the processor 1110 and the transceiver 1120 through the internal connection path. The memory 1130 is configured to store the instructions. The processor 1110 may execute the instructions stored in the memory 1130. In a possible implementation, the apparatus 1100 is configured to implement the procedures and steps corresponding to the transmitter device in the foregoing method embodiments. In another possible implementation, the apparatus 1100 is configured to implement the procedures and steps corresponding to the receiver device in the foregoing method embodiments.

It may be understood that, the apparatus 1100 may be specifically the transmitter device or the receiver device in the foregoing embodiments, or may be a chip or a chip system. Correspondingly, the transceiver 1120 may be a transceiver circuit of the chip. This is not limited herein. Specifically, the apparatus 1100 may be configured to perform steps and/or procedures corresponding to the transmitter device or the receiver device in the foregoing method embodiments.

Optionally, the memory 1130 may include a read-only memory and a random access memory, and provides instructions and data for the processor. The memory may include a nonvolatile random access memory. For example, the memory may further store information about a device type. The processor 1110 may be configured to execute the instructions stored in the memory. When the processor 1110 executes the instructions stored in the memory, the processor 1110 is configured to perform the steps and/or procedures in the foregoing method embodiments corresponding to the transmitter device or the receiver device.

In an implementation process, steps in the foregoing methods can be implemented by using a hardware integrated logic circuit in the processor, or by using instructions in a form of software. The steps of the method disclosed with reference to embodiments of this application may be directly performed by a hardware processor, or may be performed by a combination of hardware and software modules in the processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps of the foregoing method in combination with hardware of the processor. To avoid repetition, details are not described herein again.

It should be noted that, the processor in embodiments of this application may be an integrated circuit chip, and has a signal processing capability. In an implementation process, steps in the foregoing method embodiments can be implemented by using a hardware integrated logic circuit in the processor, or by using instructions in a form of software. The processor may be a general-purpose processor, a digital signal processor (digital signal processor, DSP), an ASIC, a field-programmable gate array (field-programmable gate array, FPGA) or another programmable logic device, a discrete gate or a transistor logic device, or a discrete hardware component. The processor in embodiments of this application may implement or perform the methods, the steps, and the logical block diagrams that are disclosed in embodiments of this application. The general-purpose processor may be a microprocessor, or the processor may be any conventional processor or the like. The steps of the methods disclosed with reference to embodiments of this application may be directly performed by a hardware decoding processor, or performed by a combination of hardware and software modules in the decoding processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps of the foregoing method in combination with hardware of the processor.

It may be understood that the memory in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example and not limitation, many forms of RAMs are available, such as a static random access memory (static RAM, SRAM), a dynamic random access memory (dynamic RAM, DRAM), a synchronous dynamic random access memory (synchronous DRAM, SDRAM), double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory for the system and the method described in this specification aims to include but is not limited to these memories and any memory of another appropriate type.

Optionally, the memory (for example, 1130) in embodiments of this application may be integrated into the processor (for example, 1110).

In addition, this application further provides a computer-readable storage medium. The computer-readable storage medium stores computer instructions, and when the computer instructions are run on a computer, the operations and/or procedures performed by the transmitter device or the receiver device in the method embodiments of this application are performed.

This application further provides a computer program product. The computer program product includes computer program code or instructions. When the computer program code or the instructions are run on a computer, the operations and/or procedures performed by the transmitter device or the receiver device in the method embodiments of this application are performed.

In addition, this application further provides a chip, and the chip includes a processor. A memory configured to store a computer program is disposed independent of the chip. The processor is configured to execute the computer program stored in the memory, so that an operation and/or processing performed by the transmitter device or the receiver device in any method embodiment is performed.

Further, the chip may include a communication interface. The communication interface may be an input/output interface, an interface circuit, or the like. Further, the chip may include the memory.

In addition, this application further provides a communication system, including the transmitter device and the receiver device in embodiments of this application.

It should be further noted that the memory described in this specification aims to include but is not limited to these memories and any memory of another appropriate type.

A person of ordinary skill in the art may be aware that, in combination with the examples described in embodiments disclosed in this specification, units and algorithm steps may be implemented by electronic hardware or a combination of computer software and electronic hardware. Whether the functions are implemented by hardware or software depends on specific applications and design constraints of the technical solutions. A person skilled in the art may use different methods to implement the described functions for each particular application, but it should not be considered that the implementation goes beyond the scope of this application. It may be clearly understood by a person skilled in the art that, for convenience and brevity of description, for a specific working process of the foregoing described system, apparatus, and unit, refer to a corresponding process in the foregoing method embodiments, and details are not described herein again. In the several embodiments provided in this application, it should be understood that the disclosed system, apparatus, and method may be implemented in other manners. For example, the described apparatus embodiments are merely examples. For example, division into the units is merely logical function division. In actual implementation, there may be another division manner. For example, a plurality of units or components may be combined or integrated into another system, or some features may be ignored or not performed. In addition, the displayed or discussed mutual couplings or direct couplings or communication connections may be implemented through some interfaces, and indirect couplings or communication connections between apparatuses or units may be implemented in an electrical, mechanical, or another form. The units described as separate parts may or may not be physically separate, and parts displayed as units may or may not be physical units, may be located in one place, or may be distributed on a plurality of network units. Some or all of the units may be selected according to an actual requirement to achieve the objectives of the solutions in the embodiments. In addition, functional units in embodiments of this application may be integrated into one processing unit, or each unit may exist alone physically, or two or more units may be integrated into one unit.

When the function is implemented in a form of a software functional unit and sold or used as an independent product, the function may be stored in a computer-readable storage medium. Based on such an understanding, the technical solutions of this application essentially, or the part contributing to the conventional technology, or some of the technical solutions may be implemented in a form of a software product. The computer software product is stored in a storage medium and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a ROM, a RAM, a magnetic disk, or an optical disc.

It may be understood that, an "embodiment" mentioned throughout this specification means that particular features, structures, or characteristics related to the embodiment are included in at least one embodiment of this application. Therefore, embodiments in the entire specification do not necessarily refer to a same embodiment. Further, these specific features, structures, or characteristics may be combined in one or more embodiments in any suitable manner.

It may be further understood that, in this application, both "when" and "if" mean that a network element performs corresponding processing in an objective situation, but do not constitute a limitation on time, do not require that the network element has a determining action during implementation, and do not mean other limitations either.

It may be further understood that in embodiments of this application, "B corresponding to A" indicates that B is associated with A, and B may be determined based on A. However, it may be further understood that determining B based on A does not mean that B is determined based on only A. B may alternatively be determined based on A and/or other information.

## Claims

1. A communication method based on a low-density parity-check LDPC code, wherein the method comprises:
obtaining an information bit sequence;
determining an LDPC check matrix, wherein the LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, and k corresponding to at least one 1 element in the base matrix is an integer greater than 1, wherein
Z_{c} and the k shifting values of each 1 element indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k cyclic shift matrices;
encoding the information bit sequence based on the LDPC check matrix to obtain a codeword sequence; and
outputting the codeword sequence.

2. A communication method based on a low-density parity-check LDPC code, wherein the method comprises:
obtaining a codeword sequence;
determining an LDPC check matrix, wherein the LDPC check matrix is determined based on an LDPC base matrix, a lifting size Z_{c}, a shifting value corresponding to each 1 element in the base matrix, and a quantity k of shifting values corresponding to each 1 element, k is an integer greater than or equal to 1, and k corresponding to at least one 1 element in the base matrix is an integer greater than 1, wherein
Z_{c} and the k shifting values of each 1 element indicate replacement of the corresponding 1 element with k Z_{c}×Z_{c} cyclic shift matrices, the cyclic shift matrix is obtained by cyclically shifting a Z_{c}×Z_{c} identity matrix, and the k shifting values are respectively quantities of cyclic shifts corresponding to the k cyclic shift matrices; and
decoding the codeword sequence based on the LDPC check matrix to obtain an information bit sequence.

3. The method according to claim 1 or 2, wherein the method further comprises:
determining a first indicator α(i) associated with an i^{th} row of the base matrix and a second indicator b(j) associated with a j^{th} column of the base matrix, wherein a quantity k of shifting values corresponding to the 1 element located in the i^{th} row and the j^{th} column of the base matrix is equal to α(i)×b(j), α(i) is an integer greater than or equal to 1, and b(j) is an integer greater than or equal to 1.

4. The method according to claim 3, wherein a first indicator associated with any row of the base matrix is 1, or a first indicator associated with any column of the base matrix is 1.

5. The method according to claim 3 or 4, wherein the determining the LDPC check matrix comprises:
replacing a first element in the base matrix with *α*(*i*1)×*b*(*j*1) Z_{c}×Z_{c} cyclic shift matrices, wherein the *α*(*i*1)×*b*(*j*1) Z_{c}×Z_{c} cyclic shift matrices are matrices obtained by cyclically shifting the Z_{c}×Z_{c} identity matrix based on *α*(*i*1)×*b*(*j*1) shifting values corresponding to the first element; and replacing a second element in the base matrix with *α*(*i*2)×*b*(*j*2) Z_{c}×Z_{c} all-0 matrices to obtain the LDPC check matrix, wherein
the first element is a 1 element located in a row *i*1 and a column *j*1, the second element is a 0 element located in a row *i*2 and a column *j*2, the *α*(*i*1)×*b*(*j*1) Z_{c}×Z_{c} cyclic shift matrices form one ( *α*(*i*1) ×Z_{c})×( *b*(*j*1) ×Z_{c}) matrix, and the *α*(*i*2) × *b*(*j*2) Z_{c}×Z_{c} all-0 matrices form one (*α*(*i*2)×Z_{c})×(*b*(*j*2)×Z_{c}) all-0 matrix.

6. The method according to claim 3 or 4, wherein the determining the LDPC check matrix comprises:
replacing a first element with an *α*(*i*1)×*b*(*j*1) all-1 matrix, and replacing a second element with an *α*(*i*2)×*b*(*j*2) all-0 matrix, wherein the first element is a 1 element located in a row *i*1 and a column *j*1, and the second element is a 0 element located in a row *i*2 and a column *j*2; and
replacing each 1 in the *α*(*i*1)×*b*(*j*1) all-1 matrix with a Z_{c}×Z_{c} cyclic shift matrix, wherein *α*(*i*1)×*b*(*j*1) Z_{c}×Z_{c} cyclic shift matrices after the replacement are matrices obtained by cyclically shifting the Z_{c}×Z_{c} identity matrix based on *α*(*i*1)×*b*(*j*1) shifting values corresponding to the first element; and replacing 0 in the *α*(*i*2)×*b*(*j*2) all-0 matrix with a Z_{c}×Z_{c} all-0 matrix to obtain the LDPC check matrix.

7. The method according to claim 5 or 6, wherein
the *α*(*i*1)×*b*(*j*1) shifting values of the first element are in one-to-one correspondence with the *α*(*i*1)×*b*(*j*1) Z_{c}×Z_{c} cyclic shift matrices in an order of row-first and column-second; or
the *α*(*i*1)×*b*(*j*1) shifting values of the first element are in one-to-one correspondence with the *α*(*i*1)×*b*(*j*1) Z_{c}×Z_{c} cyclic shift matrices in an order of column-first and row-second.

8. The method according to any one of claims 3 to 7, wherein the determining the first indicator *α*(*i*) associated with the i^{th} row of the base matrix and the second indicator *b*(*j*) associated with the j^{th} column of the base matrix comprises:
determining, based on first indication information, a first indicator associated with each row of the base matrix, wherein the first indication information indicates first indicators associated with all rows of the base matrix; and
determining, based on second indication information, a second indicator associated with each column of the base matrix, wherein the second indication information indicates second indicators associated with all columns of the base matrix.

9. The method according to any one of claims 3 to 7, wherein the determining the first indicator *α*(*i*) associated with the i^{th} row of the base matrix and the second indicator *b*(*j*) associated with the j^{th} column of the base matrix comprises:
determining, based on first indication information and the quantity k of shifting values corresponding to the 1 element in the base matrix, a first indicator associated with each row of the base matrix and a second indicator associated with each column of the base matrix, wherein the first indication information indicates first indicators associated with all rows of the base matrix; or
determining, based on second indication information and the quantity k of shifting values corresponding to the 1 element in the base matrix, a first indicator associated with each row of the base matrix and a second indicator associated with each column of the base matrix, wherein the second indication information indicates second indicators associated with all columns of the base matrix.

10. The method according to claim 8 or 9, wherein the first indication information is a first sequence, and/or the second indication information is a second sequence.

11. The method according to any one of claims 1 to 10, wherein quantities k of shifting values corresponding to all 1 elements in an information column of the base matrix are equal to 2, 3, 4, or 6.

12. The method according to any one of claims 1 to 11, wherein a storage matrix indicates the base matrix and the k shifting values corresponding to each 1 element in the LDPC base matrix.

13. The method according to claim 12, wherein the storage matrix comprises a first shifting value and a first function that correspond to the first element in the base matrix, the first element is a 1 element in the base matrix, a quantity k of shifting values corresponding to the first element is greater than 1, and the method further comprises:
determining, based on the first shifting value and the first function, other k-1 shifting values corresponding to the first element.

14. A communication method based on a low-density parity-check LDPC code, wherein the method comprises:
obtaining an information bit sequence;
determining an LDPC check matrix, wherein the LDPC check matrix is determined based on an LDPC base matrix, a lifting size Z_{c}, a shifting value corresponding to each 1 element in the base matrix, and a quantity of shifting values corresponding to each 1 element, the quantity of shifting values corresponding to each 1 element is k, k is an integer greater than 1, k shifting values corresponding to at least one 1 element in the base matrix comprise at least one first-type shifting value and at least one second-type shifting value, all k shifting values corresponding to a remaining 1 element other than the at least one 1 element in the base matrix are first-type shifting values, the first-type shifting value is an integer greater than or equal to 0 and less than or equal to Zₘₐₓ-1, the second-type shifting value is not equal to the first-type shifting value, and Zₘₐₓ is a maximum lifting size corresponding to Z_{c}, wherein
Z_{c} and the k shifting values of each 1 element indicate replacement of the corresponding 1 element with k1 Z_{c}×Z_{c} cyclic shift matrices and k2 Z_{c}×Z_{c} all-0 matrices, k1 and k2 are respectively a quantity of first-type shifting values and a quantity of second-type shifting values in the k shifting values of the corresponding 1 element, a sum of k1 and k2 is equal to k, the k1 Z_{c}×Z_{c} cyclic shift matrices are obtained by separately cyclically shifting a Z_{c}×Z_{c} identity matrix, and the k1 first-type shifting values are quantities of cyclic shifts corresponding to the k1 Z_{c}×Z_{c} cyclic shift matrices;
encoding the information bit sequence based on the LDPC check matrix to obtain a codeword sequence; and
outputting the codeword sequence.

15. A communication method based on a low-density parity-check LDPC code, wherein the method comprises:
obtaining an LDPC codeword sequence;
determining an LDPC check matrix, wherein the LDPC check matrix is determined based on an LDPC base matrix, a lifting size Z_{c}, a shifting value corresponding to each 1 element in the base matrix, and a quantity of shifting values corresponding to each 1 element, the quantity of shifting values corresponding to each 1 element is k, k is an integer greater than 1, k shifting values corresponding to at least one 1 element in the base matrix comprise at least one first-type shifting value and at least one second-type shifting value, all k shifting values corresponding to a remaining 1 element other than the at least one 1 element in the base matrix are first-type shifting values, the first-type shifting value is greater than or equal to 0 and less than or equal to Zₘₐₓ-1, the second-type shifting value is not equal to the first-type shifting value, and Zₘₐₓ is a maximum lifting size corresponding to Z_{c}, wherein
Z_{c} and the k shifting values of each 1 element indicate replacement of the corresponding 1 element with k1 Z_{c}×Z_{c} cyclic shift matrices and k2 Z_{c}×Z_{c} all-0 matrices, k1 and k2 are respectively a quantity of first-type shifting values and a quantity of second-type shifting values in the k shifting values of the corresponding 1 element, a sum of k1 and k2 is equal to k, the k1 Z_{c}×Z_{c} cyclic shift matrices are obtained by separately cyclically shifting a Z_{c}×Z_{c} identity matrix, and the k1 first-type shifting values are quantities of cyclic shifts corresponding to the k1 Z_{c}×Z_{c} cyclic shift matrices; and
decoding the codeword sequence based on the LDPC check matrix to obtain an information bit sequence.

16. The method according to claim 14 or 15, wherein the second-type shifting value is equal to -1.

17. The method according to any one of claims 14 to 16, wherein the method further comprises:
determining a first indicator *α* associated with each row of the base matrix and a second indicator *b* associated with each column of the base matrix, wherein a quantity k of shifting values corresponding to any 1 element in the base matrix is equal to *α* * *b*, *α* is an integer greater than or equal to 1, and *b* is an integer greater than or equal to 1.

18. The method according to claim 17, wherein a first indicator associated with any row of the base matrix is 1, or a first indicator associated with any column of the base matrix is 1.

19. The method according to claim 17 or 18, wherein the determining the LDPC check matrix comprises:
replacing a 1 element in the base matrix with k1 Z_{c}×Z_{c} cyclic shift matrices and k2 Z_{c}×Z_{c} all-0 matrices, wherein the k1 Z_{c}×Z_{c} cyclic shift matrices are matrices obtained by cyclically shifting the Z_{c}×Z_{c} identity matrix based on k1 shifting values corresponding to the 1 element; and replacing a 0 element in the base matrix with *α* * *b* Z_{c}×Z_{c} all-0 matrices to obtain the LDPC check matrix, wherein
the k1 Z_{c}×Z_{c} cyclic shift matrices and the k2 Z_{c}×Z_{c} all-0 matrices form one (*α*×Z_{c})×(*b*×Z_{c}) matrix, and the *α* * *b* Z_{c}×Z_{c} all-0 matrices form one (*α*×Z_{c})×(*b*×Z_{c}) all-0 matrix.

20. The method according to claim 17 or 18, wherein the determining the LDPC check matrix comprises:
replacing a 1 element in the base matrix with an *α*×*b* matrix, wherein k shifting values corresponding to the 1 element in the base matrix are in one-to-one correspondence with positions of k elements in the *α*×*b* matrix, and if a shifting value corresponding to a first position in the *α*×*b* matrix is the first-type shifting value, an element corresponding to the first position is 1, or if a shifting value corresponding to the first position is the second-type shifting value, an element corresponding to the first position is 0; and replacing each 0 element in the base matrix with an *α*×*b* all-0 matrix; and
replacing each 1 in the *α*×*b* matrix with a Z_{c}×Z_{c} cyclic shift matrix, wherein the cyclic shift matrix is a matrix obtained by cyclically shifting the Z_{c}×Z_{c} identity matrix based on a shifting value corresponding to a position of each 1 in the *α*×*b* matrix; replacing each 0 in the *α*×*b* matrix with a Z_{c}×Z_{c} all-0 matrix; and replacing each 0 in the *α*×*b* all-0 matrix with a Z_{c}×Z_{c} all-0 matrix to obtain the LDPC check matrix.

21. The method according to claim 19 or 20, wherein
the *k*1 shifting values of the 1 element are in one-to-one correspondence, in an order of row-first and column-second, with all Z_{c}×Z_{c} matrices in the (*α*×Z_{c})×(*b*×Z_{c}) matrix obtained by lifting the 1 element; or
the *k*1 shifting values of the 1 element are in one-to-one correspondence, in an order of column-first and row-second, with all Zc×Zc matrices in the (*α*×Z_{c})×(*b*×Z_{c}) matrix obtained by lifting the 1 element.

22. The method according to any one of claims 17 to 21, wherein the determining the first indicator *α* associated with each row of the base matrix and the second indicator *b* associated with each column of the base matrix comprises:
determining, based on first indication information, the first indicator associated with each row of the base matrix, wherein the first indication information indicates first indicators associated with all rows of the base matrix; and
determining, based on second indication information, the second indicator associated with each column of the base matrix, wherein the second indication information indicates second indicators associated with all columns of the base matrix.

23. The method according to any one of claims 17 to 21, wherein the determining the first indicator *α* associated with each row of the base matrix and the second indicator *b* associated with each column of the base matrix comprises:
determining, based on first indication information and the quantity k of shifting values corresponding to the 1 element in the base matrix, the first indicator associated with each row of the base matrix and the second indicator associated with each column of the base matrix, wherein the first indication information indicates first indicators associated with all rows of the base matrix; or
determining, based on second indication information and the quantity k of shifting values corresponding to the 1 element in the base matrix, the first indicator associated with each row of the base matrix and the second indicator associated with each column of the base matrix, wherein the second indication information indicates second indicators associated with all columns of the base matrix.

24. The method according to claim 22 or 23, wherein the first indication information is a first sequence, and/or the second indication information is a second sequence.

25. The method according to any one of claims 14 to 24, wherein k is equal to 2, 3, 4, or 6.

26. The method according to any one of claims 14 to 25, wherein a storage matrix indicates the base matrix and the k shifting values corresponding to each 1 element in the base matrix.

27. The method according to claim 26, wherein the storage matrix comprises a first shifting value and a first function that correspond to a first element in the base matrix, the first element is a 1 element in the base matrix, a quantity k1 of first-type shifting values corresponding to the first element is greater than 1, and the method further comprises:
determining, based on the first shifting value and the first function, the other k1-1 first-type shifting values corresponding to the first element.

28. A communication apparatus, comprising a processor and an interface circuit, wherein the interface circuit is configured to receive a signal from a communication apparatus other than the communication apparatus and transmit the signal to the processor, or send a signal from the processor to a communication apparatus other than the communication apparatus, and the processor is configured to implement the method according to any one of claims 1 to 27 by using a logic circuit or executing computer instructions.

29. The communication apparatus according to claim 28, further comprising a memory, wherein the memory is configured to store the computer instructions.

30. A computer-readable storage medium, wherein the storage medium stores a computer program or instructions, and when the computer program or the instructions are executed by a communication apparatus, the method according to any one of claims 1 to 27 is implemented.

31. A computer program product, comprising a computer program, wherein when the computer program is run, the method according to any one of claims 1 to 27 is implemented.

32. A communication apparatus, comprising a module or a unit configured to perform the method according to any one of claims 1 to 27.

33. A communication system, comprising a transmitter device and a receiver device, wherein the transmitter device is configured to perform the method according to any one of claims 1 or 3 to 13, or perform the method according to any one of claims 14 or 16 to 27, and the receiver device is configured to perform the method according to any one of claims 2 to 13, or perform the method according to any one of claims 15 to 27.
